# EUROPEAN PATENT SPECIFICATION

(11) **EP 2 416 372 B1**
(45) Date of publication and mention of the grant of the patent: **19.04.2017**
(21) Application number: 10758682.8
(22) Date of filing: 30.03.2010
(51) Int. Cl.: H01L 31/02, G02B 6/42

(54) **OPTICAL COMMUNICATION MODULE AND METHOD FOR MANUFACTURING OPTICAL COMMUNICATION MODULE**
OPTISCHES KOMMUNIKATIONSMODUL UND VERFAHREN ZUR HERSTELLUNG EINES OPTISCHEN KOMMUNIKATIONSMODULS
MODULE DE COMMUNICATION OPTIQUE ET PROCÉDÉ DE FABRICATION D'UN MODULE DE COMMUNICATION

(30) Priority: 30.03.2009 JP 2009082466; 30.03.2009 JP 2009082467; 02.12.2009 JP 2009274680
(43) Date of publication of application: 08.02.2012
(73) Proprietor: AutoNetworks Technologies, Ltd., Yokkaichi-shi, Mie 510-8503 (JP); Sumitomo Wiring Systems, Ltd., Yokkaichi-shi, Mie 510-8503 (JP); Sumitomo Electric Industries, Ltd., Chuo-ku Osaka-shi Osaka 541-0041 (JP)
(72) Inventor: HAYASHI, Shigeo, Yokkaichi-shi Mie 510-8503 (JP)
(74) Representative: Winter, Brandl, Fürniss, Hübner, Röss, Kaiser, Polte - Partnerschaft mbB
(86) International application number: PCT/JP2010/055629
(87) International publication number: WO 2010/113911

(56) References cited:
- JP-A- 10 056 209
- JP-A- 55 024 404
- JP-A- 2002 267 893
- JP-A- 2005 057 310
- JP-A- 2005 268 737
- JP-A- 2005 340 770
- JP-A- 2006 202 998
- US-A1- 2004 022 487
- US-A1- 2005 013 562
- US-A1- 2005 254 758

## Description

### BACKGROUND OF THE INVENTION

### 1. Field of the Invention

The present invention relates to an optical communication module that packages a photoelectric conversion device, such as a laser diode and/or photodiode utilized for performing an optical communication, and relates to a method for manufacturing the optical communication module.

### 2. Description of Related Art

Conventionally, the optical communication has become prelevant, which utilizes an optical fiber and the like. The optical communication is performed with a photoelectric conversion device such as a laser diode converting an electrical signal into an optical signal. The converted optical signal is transmitted through an optical fiber. Then, another photoelectric conversion device, such as a photodiode, converts the received optical signal into the electrical signal. Thus, a well-utilized optical communication module packages photoelectric conversion devices, such as the laser diode and/or photodiode, together with or without a peripheral circuit element for actuating the photoelectric conversion devices. Such an optical communication module is called an optical sub-assembly (OSA). Recently, several inventions are developed for the optical communication and optical communication module.

For example, Patent Document 1 proposes an optical detector applicable for communication requiring fast and wide dynamic range. In the proposed optical detector, outputs of first photodiode (optical receiver) and second photodiode (optically shielded) are input into a differential amplifier via a gain adjustment amplifier. In addition, the proposed optical detector is configured with a lowpass filter arranged between an output terminal of optical power detecting unit that detects optical power and a gain adjustment terminal of the gain adjustment amplifier.

In addition, Patent Document 2 proposes an optical receiver that can control amounts of operating current and voltage, as appropriate, and can reduce the electric power consumption. In the proposed optical receiver, a photodiode for receiving signals, a photodiode for detecting optical levels, a signal amplifier amplifying received signals and a bias current control unit controlling bias current supplied to the signal amplifier are arranged on the same board, and the bias current control unit actuates the signal amplifier when the signal current output from the photodiode for detecting optical levels becomes equal to or more than a predetermined reference value. Furthermore, the photodiode for receiving signals has a substantially circular photoresponse region smaller than the diffusion of optical signal, the photodiode for detecting optical levels has a photoresponse region that is surrounding the photoresponse region of the photodiode for receiving signals. Thus, this optical receiver can effectively detect optical signals and can improve the reception ability.

The Patent Documents 1 and 2 described above relate to peripheral circuits of the photoelectric conversion device, and try to improve the peripheral circuits for enhancing the ability of optical communication. In the Patent Documents 1 and 2, the photoelectric conversion device and peripheral circuit are arranged on a circuit board that is fixed to a lead frame and is sealed with transparent resin to form a molded unit, and a hemisphere lens unit is put on the surface of molded unit to form an optical communication module. In the optical communication module, the lens unit is arranged to be opposed to the output terminal of optical fiber.

In addition, Patent Document 3 proposes an optic-electric conversion module that has an excellent high frequency characteristic and whose size can be reduced. The optic-electric conversion module includes a photoelectric conversion device sending or receiving optical signals, a stem for fixing the photoelectric conversion device, and plural leads that apply electrical signals to the photoelectric conversion device or that send electrical signals transmitted from the photoelectric conversion device. As a package is formed with the stem and cap, a flat surface is prepared on the end portion of a predetermined lead located in the package. On the flat surface, an electrical circuit component is arranged, whose one end is connected to the photoelectric conversion device and the other end is connected to the lead.

Patent Document 4 proposes an optical device module that includes a circuit element arranged on a circuit board or the like and can actuate an optical source and/or optical detector. The optical device module contains an optical source and/or optical detector, and includes: a first package that has a first surface formed with an opening portion passing optical signals and has an opposing second surface; a second package that is formed with an opening portion containing an insertion material, such as a circuit board, and is arranged perpendicularly onto the second surface of the first package; and a lead frame that mechanically connects the first package to second package, and electrically connects the optical source and/or optical detector in the first package to a connection point exposed within the opening portion of second package. In the optical device module, the insertion material, such as a circuit board, is further mechanically connected to the second package and electrically connected to the connection point in the opening portion. Furthermore, a lens block holding the lens is fixed to the first package in this optical device module, and an optical fiber is fit into an opening portion formed on the lens block.

Patent Document 5 proposes a method for manufacturing a lead frame connector that is utilized for connecting an optic sub assembly to a printed circuit board (PCB) in an optical communication module. In this method, a shape of conductor is stamped on a conductive ribbon, the conductor is bent appropriately, an injection molding process with the open reel system is utilized to form a case insulating the conductor, and then, the conductive ribbon is cut to configure a single lead frame connector. It is possible to electrically isolate plural conductors contained in one case from each other, by punching the connecting portion through the hole formed in the case.

In a conventional optical communication module, a photoelectric conversion device (and peripheral circuit) is generally mounted on a lead frame, the photoelectric conversion device and lead frame are generally sealed with transparent resin, and further a lens is generally formed integrally with resin material. If the precision for forming the resin part is low, the position of lens may not match with the position of photoelectric conversion device in such a conventional configuration described above. Thus, the performance of optical communication may be reduced. In addition, it is required to select resin material in consideration of the heat resistance to be provided to the photoelectric conversion device, because the photoelectric conversion device is exposed to high temperature environments during the resin sealing. Thus, there is a limitation of resin materials to be selected. Therefore, it is difficult to solve such a problem because the resin material should be selected to implement the high precision for forming the resin part.

As utilized for performing the optical communication, an optical fiber is configured with a core that passes light and with a clad that surrounds the core and confines light. There are various types of optical fiber, based on the material of core and the material of clad: a hard polymer clad fiber (HPCF) in which the clad made of high strength plastic surrounds the core made of silica glass, an all silica glass fiber (AGF) in which the core and clad are made of silica glass, and the like. The optical fiber is selected in consideration of communication speed, cost and the like. The HPCF is selected for the optical communication having a relatively slow speed, and the diameter of core is about 200 µm. The AGF is selected for the optical communication having a relatively high speed, and the diameter of core is about several micrometers to tens of micrometers. In contrast, the laser diode has a light emitting part whose size is about several micrometers to tens of micrometers, and the photodiode has a light receiving part whose size is about tens of micrometers. Therefore, it is required for the AGF including the core whose diameter is relatively small to perform the position adjustment to the light emitting part of laser diode or to the light receiving part of photodiode.

In Patent Documents 1 and 2, the photoelectric conversion device is sealed with resin to form a molded unit and the lens unit is arranged on the molded unit. Thus, the position of photoelectric conversion device may not match to the position of lens unit, if the precision for forming the lens unit with resin is low. Hence, the performance of optical communication may be reduced. In addition, the output terminal of optical fiber must be configured to be opposed to the lens unit in the arranged optical communication module of Patent Documents 1 and 2. The position adjustment for the configuration is performed by inserting the optical fiber and communication module into a groove formed on another part. However, it is difficult to completely adjust and match the positions only by inserting the optical fiber and communication module into the groove formed on another part, and it is required to perform further position adjustment for the optical fiber and lens unit, because there are problems about the precision for forming the molded unit of communication module and for forming said another part on which the groove is formed to insert therein the communication module in the case that the optical fiber, such as the AGF, is selected for the optical communication having a relatively high speed.

The optic-electric conversion module of Patent Document 3 includes the photoelectric conversion device fixed to the stem and covered by the cap, instead of being sealed with resin. Thus, the lens is formed integrally with the cap. Therefore, it is required to precisely adjust and match the position of cap and the position of photoelectric conversion device. Furthermore, it is required to adjust and match the position of optic-electric conversion module and the position of optical fiber. If the precisions for adjusting and matching the positions are low, the performance of optical communication with the optic-electric conversion module may be reduced.

Patent Document 1: Japanese Patent Application Laid-Open No. 2006-40976
Patent Document 2: WO 01/015348
Patent Document 3: Japanese Patent Application Laid-Open No. 2005-167189
Patent Document 4: US Patent No. 7,455,463
Patent Document 5: US Patent No. 7,370,414

Further relevant prior art can be found in documents US2005/0013562, JP2005-340770, and US2004/0022487.

### SUMMARY OF THE INVENTION

The present inventors have proposed the optical communication module according to claim 1 and the corresponding method as claimed in claim 10, in which the transparency maintaining unit having a transparent portion supports the electric conductor having an opening portion to partially expose the electric conductor, the lens is arranged integrally with the transparent portion, the photoelectric conversion device includes the light emitting unit or light receiving unit and the connector on the same surface, and the photoelectric conversion device is connected to an exposed portion of the electric conductor, arranged on the transparency maintaining unit and then sealed, in order to solve the problem that the performance of optical communication is reduced because of the positional mismatch of photoelectric conversion device and lens, the positional mismatch of lens and optical fiber, and the like. It is possible in this optical communication module to precisely form the transparency maintaining unit, lens and the like, and to precisely arrange the photoelectric conversion device, because the position of photoelectric conversion device is determined to arrange the photoelectric conversion device after the transparency maintaining unit, lens and the like are formed with resin. Therefore, this optical communication module has the advantage that can prevent the positional mismatch of photoelectric conversion device and lens.

Furthermore, this optical communication module proposed by the present inventors can be configured to include the cylindrical portion protruding from the transparency maintaining unit and surrounding the lens, and to include the optical fiber fit into the cylindrical portion. Because the cylindrical portion can be formed precisely and integrally together with the transparency maintaining unit, the position of optical fiber can be precisely determined by fitting the optical fiber to the cylindrical portion. Therefore, this optical communication module has the advantage that can prevent the positional mismatch of lens and optical fiber. As described above, the present inventors have proposed the optical communication module for solving the problem that the performance of optical communication is reduced because of the positional mismatch of photoelectric conversion device and lens, the positional mismatch of lens and optical fiber and the like.

However, the optical communication module described above includes the photoelectric conversion device at one side of transparency maintaining unit and includes the lens at the other side. Thus, it is general for forming the transparency maintaining unit and lens with ease and low cost, to utilize the injection molding method with transparent synthetic resin. For example, the injection molding method can be implemented with two molds. Assume the case that one mold is utilized for forming said one side at which the photoelectric conversion device is arranged and the other mold is utilized for forming the other side at which the lens is arranged. When the precision for aligning these two molds is not high, the performance of optical communication may be reduced because the formed one side of transparency maintaining unit does not match the formed other side of transparency maintaining unit and the arranged position of photoelectric conversion device does not match the formed position of lens.

The photoelectric conversion device may be packaged together with another circuit component. For example, it is possible to package the photodiode and amplifier circuit that amplifies voltage/current generated in response to the photodiode detecting light. Additionally, it is possible to package the laser diode and driver circuit that generates voltage/current required for making the laser diode emit light. In the case of utilizing the optical communication module packaged together with another circuit, the communication apparatus does not require to include such an additional circuit. Thus, it may be possible to reduce the size and cost of communication apparatus. However, such an optical communication module is desired to be small.

The optical device module of Patent Document 4 is formed with a complex configuration: the second package is arranged perpendicular onto the fist package containing the optical source and/or optical detector; the circuit board is arranged in the opening portion of second package; and the lens block is fixed to the first package. Thus, it is difficult to reduce the size of optical device module. Particularly, the size of circuit board and size of second package including the circuit board may be increased. In addition, it is difficult to reduce the cost of optical device module and to simplify the manufacturing processes of optical device module, because of many parts. The optical communication module utilizing the lead frame of Patent Document 5 is also configured similarly.

The present invention is made in view of such circumstances, and has an object to provide an optical communication module and method for manufacturing the optical communication module, which can prevent the reduction of optical communication performance, even in the case that a position of mold for forming one side of transparency maintaining unit holding the photoelectric conversion device does not match to a position of mold for forming the other side of transparency maintaining unit holding the lens when the injection molding is performed for integrally forming the transparency maintaining unit holding the photoelectric conversion device and the lens integrally formed with the transparency maintaining unit.

Another object of the present invention is to provide an optical communication module which can prevent deterioration of communication performance caused by the improper positions of light emitting unit or light receiving unit in the photoelectric conversion device, lens, optical fibers and the like, which can reduce the number of required parts and which can reduce the size.

An optical communication module according to one aspect of the present invention includes: a photoelectric conversion device that is provided with a photoelectric conversion unit and a connector on one surface of the photoelectric conversion device, wherein the photoelectric conversion unit performs a photoelectric conversion from an optical signal to an electrical signal or from an electrical signal to an optical signal with receiving or emitting light, and the connector connects the photoelectric conversion device to another device; an electric conductor that is connected to the connector of the photoelectric conversion device and is provided with an optical pass portion that passes light toward the photoelectric conversion unit of the connected photoelectric conversion device; and a transparency maintaining unit that passes light, includes a surface lens integrally formed on a front surface of the transparency maintaining unit and another surface lens integrally formed on a back surface of the transparency maintaining unit, and supports the electric conductor to expose a portion connecting the photoelectric conversion device, wherein the photoelectric conversion device is connected to the exposed portion of the electric conductor to arrange the photoelectric conversion unit opposite to one of the surface lenses of the transparency maintaining unit, and transmission of an optical signal is performed through the surface lenses of the transparency maintaining unit and the optical pass portion of the electric conductor.

In addition, an optical communication module according to another aspect of the present invention comprises the surface lenses that are formed respectively by molds different from each other.

In addition, an optical communication module according to another aspect of the present invention includes the transparency maintaining unit that comprises a recess portion that accommodates the photoelectric conversion device, and the optical communication module further comprises a cover that seals the recess portion.

In addition, an optical communication module according to another aspect of the present invention further includes one or more electrical circuit components that are connected to the exposed portion of the electric conductor which is exposed to outside the recess portion of the transparency maintaining unit.

In addition, an optical communication module according to another aspect of the present invention includes another of the electric conductor, wherein the photoelectric conversion device and the electrical circuit component are electrically connected through the electric conductors, to configure an electrical circuit for performing a photoelectric conversion.

In addition, an optical communication module according to another aspect of the present invention includes the electrical circuit component that is connected to the electric conductor with a soft solder including a flux.

In addition, an optical communication module according to another aspect of the present invention further includes a cylindrical portion that is arranged protrudent to surround another surface lens on the transparency maintaining unit and that internally fits to a communication line utilized for performing an optical communication, wherein the photoelectric conversion device performs a transmission of an optical signal through inside the cylindrical portion, through the surface lenses of transparency maintaining unit and through the optical pass portion of the electric conductor.

In addition, an optical communication module according to another aspect of the present invention further includes a positioning unit that is arranged protrudent on the transparency maintaining unit and defines a position for arranging the photoelectric conversion device.

In addition, an optical communication module according to another aspect of the present invention includes: the transparency maintaining unit that comprises a projection that defines a position for supporting the electric conductor; and the electric conductor that comprises a hole portion or a concave portion that fits to the projection of the transparency maintaining unit.

In addition, an optical communication module according to another aspect of the present invention includes the surface lenses that are formed to convert light, which comes from one of the surface lenses, passes the transparency maintaining unit and then reaches to another of the surface lenses, into parallel light.

In addition, a method according to another aspect of the present invention for manufacturing an optical communication module comprising: a photoelectric conversion device that is provided with a photoelectric conversion unit and a connector on one surface of the photoelectric conversion device, wherein the photoelectric conversion unit performs a photoelectric conversion from an optical signal to an electrical signal or from an electrical signal to an optical signal with receiving or emitting light, and the connector connects the photoelectric conversion device to another device; an electric conductor that is connected to the connector of the photoelectric conversion device and is provided with an optical pass portion that passes light toward the photoelectric conversion unit of the connected photoelectric conversion device; and a transparency maintaining unit that passes light, includes a surface lens integrally formed on a front surface of the transparency maintaining unit and another surface lens integrally formed on a back surface of the transparency maintaining unit, and supports the electric conductor to expose a portion connecting the photoelectric conversion device, includes a resin molding step for integrally forming the transparency maintaining unit and the surface lenses made of transparent synthetic resin with plural molds, wherein the surface lenses of transparency maintaining unit are respectively formed by the molds different from each other; and a connection step for determining a position of the photoelectric conversion device relative to one of the surface lenses or a portion of the transparency maintaining unit formed by a mold utilized for said one of the surface lenses, and then connecting the connector to the exposed portion of the electric conductor.

In addition, a method according to another aspect of the present invention for manufacturing an optical communication module includes the optical communication module that comprises a positioning unit that is arranged protrudent on the transparency maintaining unit and defines a position for arranging the photoelectric conversion device, and the position of the photoelectric conversion device is determined to be the position defined by the positioning unit and then a connection is performed, in the connection step.

In addition, a method according to another aspect of the present invention for manufacturing an optical communication module includes the transparency maintaining unit of the optical communication module that comprises a recess portion that accommodates the photoelectric conversion device, and the method further includes a sealing step for sealing the recess portion with a cover after the connection step.

In addition, a method according to another aspect of the present invention for manufacturing an optical communication module includes a plurality of the transparency maintaining units that are formed integrally in the resin molding step, and the method further includes: a separating step for dicing and separating the plurality of transparency maintaining units formed integrally; and an arranging step for arranging the electric conductor on the separated transparency maintaining unit.

In addition, a method according to another aspect of the present invention for manufacturing an optical communication module further includes a projection defining a position for defining the position of electric conductor arranged on each transparency maintaining unit that is formed integrally in the resin molding step, and a position of the electric conductor is determined by engaging a hole portion or concave portion of the electric conductor with the projection of transparency maintaining unit, in the arranging step.

In one aspect of the present invention, the photoelectric conversion device is utilized (e.g., laser diode or photodiode), in which the connector for connecting an electric conductor (e.g., lead frame) is arranged on one surface where the photoelectric conversion unit (e.g., light emitting unit, light receiving unit, optical receiver) is arranged. The optical pass portion for passing light (e.g., opening portion or notch) is arranged at the electric conductor that is connected to the photoelectric conversion device. This electric conductor is supported by the transparency maintaining unit that passes light, such that the portion for connecting the photoelectric conversion device is exposed. In addition, the surface lens is formed integrally on the front surface of transparency maintaining unit and another surface lens is formed integrally on the back surface of transparency maintaining unit.

The photoelectric conversion device is connected to the electric conductor exposed to the transparency maintaining unit, and emits and receives light through two surface lenses of transparency maintaining unit and through the optical pass portion of electric conductor, to perform the transmission of optical signals.

Because of these configurations, the transparency maintaining unit is transparent and is arranged between these two surface lenses. For example, the light emitted by the photoelectric conversion device is thus converted into the substantial parallel light by the first surface lens, passes through the transparency maintaining unit to the second surface lens, and is focused into the optical fiber and the like by the second surface lens. For example, the light emitted by the optical fiber is, on the contrary, converted into the substantially-parallel light by the second surface lens, passes through the transparency maintaining unit to the first surface lens, and is focused into the photoelectric conversion device by the first surface lens.

As described above, the light coming from either of these surface lenses can be converted into the parallel light during passage through the transparency maintaining unit. Thus, the light coming from the first surface lens can be focused into the photoelectric conversion device or the light coming from the second surface lens can be focused into the optical fiber, even in the case that the center of one surface lens at one side of transparency maintaining unit does not match to the center of the other surface lens at the other side of transparency maintaining unit because of the positional gap for these two molds. Therefore, the optical communication module according to the present invention can prevent the reduction of communication performance, even when the precision for the positions of two surface lenses is low because of the positional gap for these molds.

In one aspect of the present invention, two surface lenses are respectively formed by molds different from each other. In other words, one side of transparency maintaining unit where the first surface lens is arranged is formed by the mold that is different from the other mold for forming the other side of transparency maintaining unit where the second surface lens is arranged. As described above, the optical communication module according to the present invention can prevent the reduction of communication performance even when the centers of two surface lenses do not match with each other. Therefore, it is possible to form the transparency maintaining unit made of transparent synthetic resin, with ease and low cost.

In one aspect of the present invention, the recess portion is configured in the transparency maintaining unit for accommodating the photoelectric conversion device, the portion of electric conductor is exposed inside the recess portion, and the photoelectric conversion device is connected to this exposed portion, to arrange the photoelectric conversion device in the transparency maintaining unit. Thus, the cover sealing the recess portion can be utilized for sealing the photoelectric conversion device. The cover can be attached easily to the transparency maintaining unit by a connection method such as ultrasonic welding or using adhesive. The photoelectric conversion device can be sealed with ease and low cost, because higher precision for forming the cover is not required and higher precision for connecting the cover is not required.

In one aspect of the present invention, electrical circuit components, such as a resistance, capacitor, coil, integrated circuit (IC) and/or the like, for configuring an electrical circuit are connected to the electric conductor exposed to the transparency maintaining unit,. Thus, the optical communication module does not require the circuit board and the like, but can arrange the electric circuit components in the transparency maintaining unit, i.e., can include the electric circuit required for performing the optical communication. Because it is configured that the electric conductor for connecting the photoelectric conversion device is utilized to arrange the electrical circuit components, it is possible to reduce the size of optical communication module.

In one aspect of the present invention, the transparency maintaining unit includes plural electric conductors. Plural electric conductors can be utilized as wire portions of electric circuit. Thus, the electric circuit can be configured with the electric conductors for properly connecting the photoelectric conversion device and electrical circuit components. For example, the photoelectric conversion device and electrical circuit components of optical communication module can be utilized for configuring the electric circuit for performing the photoelectric conversion (electric circuit related to the operation of photoelectric conversion device), such as an amplifying circuit for amplifying the output of photodiode or a driving circuit for a laser diode. Therefore, it is possible to prevent the optical communication module from becoming larger, to provide the optical communication module having higher convenience, and to implement a smaller communication apparatus including such an optical communication module.

In one aspect of the present invention, the electrical circuit component is connected to the electric conductor with the soft solder including flux. Thus, circuit components can be connected by a so-called solder reflow method: printing the soft solder including flux on the board; putting circuit components on the printed soft solder; and heating and melting the soft solder to connect the put circuit components.

Generally speaking, the flux utilized in the solder reflow method is not preferred for the photoelectric conversion device, IC chip or the like electrically connected by a wire bonding method and the like. However, the optical communication module according to the present invention is configured with the photoelectric conversion device sealed with the peripheral wall and cover. Hence, the electrical circuit components can be connected by the solder reflow method after the cover is fixed to the peripheral wall. Therefore, it is possible to facilitate arrangement of the electrical circuit component in the optical communication module.

In one aspect of the present invention, the cylindrical portion is arranged on the transparency maintaining unit to surround the surface lens. The cylindrical portion is configured to internally fit the communication line, such as the optical fiber. Thus, it is configured to perform the transmission of optical signals between the photoelectric conversion device and communication line through these two surface lenses and optical pass portion of electric conductor. Thus, the photoelectric conversion device can emit light to the communication line fit to the cylindrical portion, or can receive the light emitted from the communication line. Hence, it is possible to adjust the positions of photoelectric conversion device and communication line, only by fitting the communication line to the cylindrical portion configured precisely. Therefore, it is possible to facilitate connecting of the optical communication module and communication line, and to enhance the communication performance.

In one aspect of the present invention, the transparency maintaining unit of optical communication module includes the positioning unit protruding for defining the arrangement position of photoelectric conversion device. Because the transparency maintaining unit of optical communication module can be formed precisely, it is possible to precisely form the positioning unit that is protruding. Thus, the photoelectric conversion device can be precisely connected to the electric conductor based on the positioning unit, in the process for manufacturing the optical communication module. Therefore, it is possible to enhance the communication performance of optical communication module.

In one aspect of the present invention, the projection is arranged on the transparency maintaining unit, the hole portion or concave portion is arranged on the electric conductor, and the projection of transparency maintaining unit is engaged to the hole portion or concave portion of electric conductor, for determining the positions of transparency maintaining unit and electric conductor. Thus, it is possible to easily and precisely arrange the electric conductor on the separately-manufactured transparency maintaining unit, for making the transparency maintaining unit hold the electric conductor. Therefore, it is possible not only to enhance the transmission of optical signal performed by the optical communication module, but also to simplify the process for manufacturing the optical communication module and to reduce the cost for the manufacturing process.

In one aspect of the present invention, shapes of two surface lenses formed on the transparency maintaining unit are determined to convert the light passing from one surface lens to the other surface lens, i.e., the light passing inside the transparency maintaining unit, into the parallel light. Thus, the photoelectric conversion device or optical fiber can obtain the light focused from the light passing from one surface lens to the other surface lens. Therefore, it is possible to prevent the reduction of communication performance.

In one aspect of the present invention, the transparency maintaining unit including the electric conductor and these two surface lenses are integrally formed with transparent synthetic resin, for manufacturing the optical communication module described above. It should be noted that one surface lens of transparency maintaining unit is formed by a mold different from the mold for forming the other surface lens of transparency maintaining unit. Even when the positional gap is caused in these two surface lenses at that time, the configurations of optical communication module can prevent the reduction of communication performance. Therefore, higher precision may be not required for adjusting the positions of these two molds.

After the transparency maintaining unit is formed, the connector of photoelectric conversion device is connected to the exposed portion of electric conductor, to arrange the photoelectric conversion device in the transparency maintaining unit. At that time, the position of photoelectric conversion device is determined relative to the first surface lens or a portion of transparency maintaining unit formed with the mold utilized for forming the first surface lens, and the center of photoelectric conversion unit in the photoelectric conversion device is adjusted to match the center of first surface lens. In the case that the optical communication module is mounted on a communication apparatus, the center of optical fiber may be adjusted relative only to the second surface lens arranged at the other side of transparency maintaining unit. Thus, the light can be precisely focused into the photoelectric conversion device by the first surface lens, or the light may be precisely focused into the optical fiber by the second surface lens. Therefore, it is possible to perform the optical communication, precisely.

In one aspect of the present invention, the positioning unit is configured to protrude at said one side where the electric conductor is exposed in the transparency maintaining unit of optical communication module. The positioning unit is arranged with higher precision for determining the position of positioning unit relative to the center of surface lens arranged on the transparency maintaining unit.

The positioning unit on the transparency maintaining unit is utilized as the reference for determining the position of photoelectric conversion device, when the photoelectric conversion device is connected to the electric conductor. Because the transparency maintaining unit of optical communication module can be formed precisely and the positioning unit can be configured to precisely protrude, the position of photoelectric conversion device can be determined precisely relative to the surface lens. Therefore, it is possible to precisely connect the photoelectric conversion device to the electric conductor.

In one aspect of the present invention, the transparency maintaining unit previously includes the recess portion in which the electric conductor is exposed, and the photoelectric conversion device is accommodated into the recess portion to be connected with the electric conductor. The photoelectric conversion device is sealed by attaching the cover that seals the recess portion, after the photoelectric conversion device is connected to the electric conductor. The cover can be attached easily by a connecting method, for example, of utilizing ultrasonic welding or adhesive. The higher precision is not required for attaching the cover. Therefore, it is possible to seal the photoelectric conversion device with ease and low cost.

In one aspect of the present invention, many transparency maintaining units are integrally formed with transparent resin, and then the transparency maintaining units are separated from each other to manufacture the transparency maintaining unit in the process for manufacturing the optical communication module. The electric conductor is arranged on each of the separated transparency maintaining unit, and is connected to the photoelectric conversion device, and the electric conductor and photoelectric conversion device are sealed, for manufacturing the optical communication module.

Therefore, it is possible to reduce the manufacturing cost for the resin sealing and reduce the cost for manufacturing the optical communication module, in comparison to the case that the resin molding is performed for the photoelectric conversion device and another resin molding is independently performed for the electric conductor.

In one aspect of the present invention, the projection is integrally formed on the transparency maintaining unit when the transparency maintaining unit is formed with resin, as the projection is configured to engage with the hole portion or concave portion arranged on the electric conductor. Thus, the projection of transparency maintaining unit can be engaged with the hole portion or concave portion of electric conductor to determine the position, in the process for arranging the electric conductor on the transparency maintaining unit. Therefore, it is possible to facilitate manufacturing of the optical communication module and to reduce the cost for manufacturing the optical communication module.

It is configured in the present invention that the surface lenses are respectively formed on the front side and back side of transparency maintaining unit including the electric conductor, the photoelectric conversion device is connected to the electric conductor including the optical pass portion, and the photoelectric conversion device performs the transmission of optical signals through these two surface lenses and optical pass portion of electric conductor. Thus, the light emitted by the photoelectric conversion device can be converted into the substantially-parallel light by the first surface lens, can pass through the transparency maintaining unit to the second surface lens, and can be focused into the optical fiber and the like by the second surface lens, or the light emitted by the optical fiber can be converted into the substantially-parallel light by the second surface lens, can pass through the transparency maintaining unit to the first surface lens, and can be focused into the photoelectric conversion device by the first surface lens. Therefore, it is possible to precisely perform the transmission of optical signals between the photoelectric conversion device and optical fiber and to prevent the reduction in optical communication performance, even in the case that a positional gap is caused in the positions of molds while the integral configurations are formed with transparent synthetic resin and the positions of surface lenses on the transparency maintaining unit do not match with each other.

In addition, because the electrical circuit components are connected to the electric conductor exposed to the transparency maintaining unit, the optical communication module can include the electrical circuit components with the electric conductor connecting the photoelectric conversion device, but without the circuit board. Hence, the electrical circuit can be configured with these electrical circuit components and electric conductor. Therefore, it is possible to implement the optical communication module that includes the photoelectric conversion device integrally formed together with the electrical circuit components, requires smaller number of parts, has a smaller size, and can perform the optical communication with higher precision.

The above and further objects and features of the invention will more fully be apparent from the following detailed description with accompanying drawings.

### BRIEF DESCRIPTION OF THE DRAWINGS

FIG. 1 is a schematic cross section view showing a configuration of optical communication module according to the present invention.
FIG. 2A is a schematic view showing a configuration of photoelectric conversion device included in the optical communication module according to the present invention.
FIG. 2B is a schematic view showing another configuration of photoelectric conversion device included in the optical communication module according to the present invention.
FIG. 2C is a schematic view showing another configuration of photoelectric conversion device included in the optical communication module according to the present invention.
FIG. 3 is a schematic flat view showing a configuration of conductive plate included in the optical communication module according to the present invention.
FIG. 4 is a schematic view explaining a method for manufacturing the optical communication module according to the present invention.
FIG. 5 is another schematic view explaining the method for manufacturing the optical communication module according to the present invention.
FIG. 6 is another schematic view explaining the method for manufacturing the optical communication module according to the present invention.
FIG. 7 is another schematic view explaining the method for manufacturing the optical communication module according to the present invention.
FIG. 8 is another schematic view showing the method for manufacturing the optical communication module according to the present invention.
FIG. 9A is a schematic view for explaining configurations of the first surface lens and the second surface lens included in the optical communication module according to the present invention.
FIG. 9B is another schematic view for explaining configurations of the first surface lens and the second surface lens included in the optical communication module according to the present invention.
FIG. 9C is another schematic view for explaining configurations of the first surface lens and the second surface lens included in the optical communication module according to the present invention.
FIG. 10 is a schematic cross section view showing a configuration of optical communication module in a variation according to the present invention.
FIG. 11 is a schematic cross section view showing a configuration of optical communication module in an embodiment 2 according to the present invention.
FIG. 12 is a schematic flat view showing a configuration of optical communication module in the embodiment 2 according to the present invention.
FIG. 13 is a circuit diagram showing an example of reception circuit configured with the conductive plate of OSA.
FIG. 14 is a schematic view explaining a method for manufacturing the optical communication module in the embodiment 2 according to the present invention.
FIG. 15 is another schematic view explaining the method for manufacturing the optical communication module in the embodiment 2 according to the present invention.
FIG. 16 is another schematic view explaining the method for manufacturing the optical communication module in the embodiment 2 according to the present invention.
FIG. 17 is another schematic view explaining the method for manufacturing the optical communication module in the embodiment 2 according to the present invention.
FIG. 18 is another schematic view explaining the method for manufacturing the optical communication module in the embodiment 2 according to the present invention.
FIG. 19 is a schematic cross section view showing a configuration of the optical communication module in a variation 1 of embodiment 2 according to the present invention.
FIG. 20 is a schematic cross section view showing a configuration of the optical communication module in an embodiment 3 according to the present invention.
FIG. 21 is a schematic flat view showing a configuration of conductive plate included by the optical communication module of embodiment 3 according to the present invention.
FIG. 22 is a schematic view explaining a method for manufacturing the optical communication module in the embodiment 3 according to the present invention.
FIG. 23 is another schematic view explaining the method for manufacturing the optical communication module in the embodiment 3 according to the present invention.
FIG. 24 is another schematic view explaining the method for manufacturing the optical communication module in the embodiment 3 according to the present invention.
FIG. 25 is another schematic view explaining the method for manufacturing the optical communication module in the embodiment 3 according to the present invention.
FIG. 26 is another schematic view explaining the method for manufacturing the optical communication module in the embodiment 3 according to the present invention.
FIG. 27 is another schematic view explaining the method for manufacturing the optical communication module in the embodiment 3 according to the present invention.
FIG. 28 is a schematic cross section view showing a configuration of optical communication module in a variation 1 of embodiment 3 according to the present invention.
FIG. 29 is a schematic cross section view showing a configuration of optical communication module in a variation 2 of embodiment 3 according to the present invention.

### DESCRIPTION OF THE PREFERRED EMBODIMENTS

### (Embodiment 1)

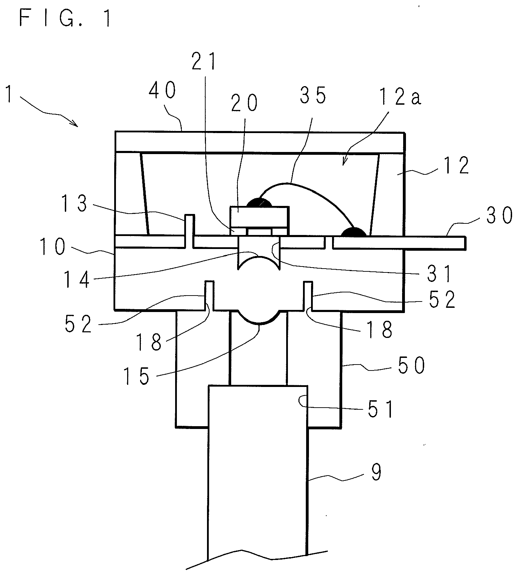

The present invention will be described in reference to figures that show embodiments according to the present invention. FIG. 1 is a schematic cross section view showing a configuration of optical communication module according to the present invention. The numeral "1" in figures represents an OSA in which a photodiode (photoelectric conversion device) 20 is packaged. The OSA 1 corresponds to an optical communication module according to the present invention. An optical fiber (communication line) 9 is connected to the OSA 1. The OSA 1 is a device for utilizing the photodiode 20 to receive the light emitted from another device through the optical fiber 9, converting an optical signal into an electrical signal and outputting the electrical signal to perform an optical communication.

The OSA 1 includes a plate-shaped basement (transparency maintaining unit) 10 that is approximately square in plain view. The photodiode 20 is connected to one surface of basement 10 (upper surface in FIG. 1; said one surface is simply called the "upper surface", hereinafter), and a cylindrical portion 50 for connecting the optical fiber 9 is formed on the other surface of basement 10 (lower surface in FIG. 1; said other surface is simply called the "lower surface", hereinafter). A peripheral wall 12 is formed along the periphery on the upper surface. The upper surface and peripheral wall 12 of basement 10 configure a recess portion 12a that accommodates the photodiode 20.

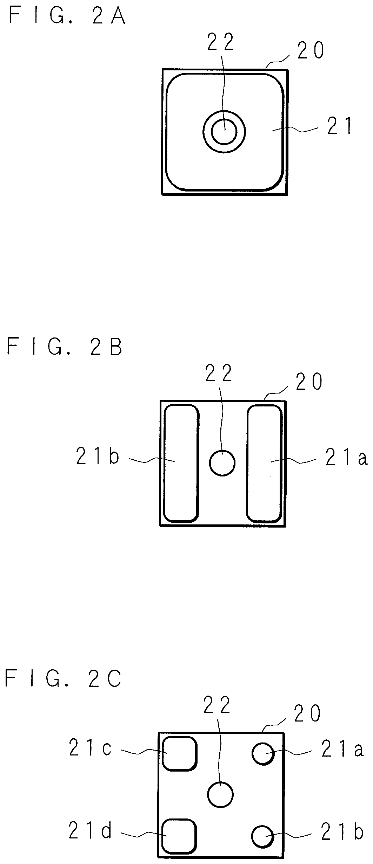

FIGs. 2A-2C are schematic views showing a configuration of photoelectric conversion device included in the optical communication module according to the present invention. They illustrate three examples of configuration about the lower surface of photodiode 20. The photodiode 20 is approximately square shaped plate in a plain view. An optical receiver (photoelectric conversion unit) 22 is formed at a substantial center on the lower surface of photodiode 20, which converts an optical signal into an electrical signal in response to detection of light. One or more connectors 21 are arranged around the optical receiver 22. The connector 21 is an electric terminal for inputting and outputting the electrical signal of photodiode 20, and for connecting the photodiode 20 to a conductive plate 30 with soft solder, conductive adhesive or the like.

For example, it is possible to form the connector 21 in an annular shape surrounding the optical receiver 22 (see FIG. 2A). In this example, only one connector 21 can be arranged on the lower surface of photodiode 20. However, the photodiode 20 requires two electric terminals for outputting and inputting signals. Thus, it is required to arrange another connector on the upper surface, side surface or the like. In this embodiment, another connector (not shown in figures) is arranged on the upper surface of photodiode 20, and a metal wire 35 electrically connects the connector on the upper surface to the conductive plate 30.

Alternatively, two connectors 21a, 21b may be arranged on the lower surface of photodiode 20 (see FIG. 2B). In this alternative case, each of connectors 21a, 21b may be formed in an approximately-rectangular shape and arranged to sandwich the optical receiver 22. Alternatively, dummy connectors 21c, 21d may be arranged, together with the connectors 21a, 21b that are utilized for inputting and outputting electrical signals (see FIG. 2C). The dummy connectors 21c, 21d are utilized for the connection with soft solder, conductive adhesive or the like, but not for inputting and outputting electrical signals. In this latter alternative case, four connectors 21a-21d may be arranged at the four corners on the lower surface of photodiode 20.

The following description and figures are explained in the context of OSA 1 including the photodiode 20 shown in FIG. 2A.

A metal conductive plate 30 is implanted into the basement 10 of OSA 1, and one surface of conductive plate 30 is exposed in the recess portion 12a. The conductive plate 30 is connected to the connector 21 of photodiode 20 with soft solder, conductive adhesive or the like at its own part exposed in the recess portion 12a, or connected with the wire 35 to the electric terminal arranged on the upper surface of photodiode 20, for transmitting electrical signals between the photodiode 20 and the external device. In other words, the conductive plate 30 is a wiring for connecting components in the reception circuit that utilizes the photodiode 20.

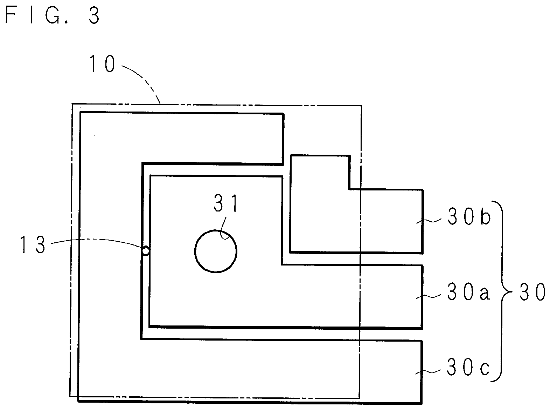

FIG. 3 is a schematic flat view showing a configuration of conductive plate 30 included in the optical communication module according to the present invention. FIG. 3 shows the outline of basement 10 illustrated by the two-dot chain line which is overlaid on the upper surface of conductive plate 30. In the example of figures, the OSA 1 includes three conductive plates 30a-30c. The first conductive plate 30a is configured with a substantially-square part arranged at the center of basement 10 and with an extension part extending from the square part to the outside. An opening portion 31 is formed at the substantial center of square part, which has a substantially-circular shape and works as an optical pass portion for passing light. The first conductive plate 30a is fixed to the basement 10, and the opening portion 31 is located at the substantial center of basement 10 in a plain view. The diameter of opening portion 31 is shorter than one side of photodiode 20 on the lower surface, but longer than the diameter of optical receiver 22 included in the photodiode 20. The connector 21 of photodiode 20 is connected to the periphery of opening portion 31 on the first conductive plate 30a, with soft solder or conductive adhesive.

The second conductive plate 30b is formed in a substantially-"L" shape. The second conductive plate 30b is aligned with the first conductive plate 30a, and one end portion of second conductive plate 30b is extending from the basement 10 to the outside. The second conductive plate 30b is connected to the electric terminal arranged on the upper surface of photodiode 20 with the wire 35. The third conductive plate 30c is formed in a substantially-"U" shape. The third conductive plate 30c is arranged to surround the first conductive plate 30a and one end portion of third conductive plate 30b is extending from the basement 10 to the outside. The third conductive plate 30c is utilized for the purpose of shielding the OSA 1. For example, the third conductive plate 30c is connected at a ground potential for the purpose. The extension parts of conductive plates 30a-30c extending from the basement 10 are utilized as electric terminals that connect the OSA 1, for example, to a circuit board of communication apparatus.

A positioning unit 13 protrudes into the recess portion 12a from the upper surface of basement 10 included in the OSA 1, and is formed in a round rod shape. The positioning unit 13 is utilized as a positional reference for connecting the photodiode 20 to the conductive plate 30 (30a) within the recess portion 12a. It is configured to accurately define the distance between the center of opening portion 31 on the conductive plate 30 fixed to the basement 10 (or the center of first surface lens 14 described later) and the position of positioning unit 13. For connecting the photodiode 20 to the conductive plate 30, it may be configured to utilize a manufacturing equipment that captures the image of upper surface of basement 10, for example, with a camera and connects the photodiode 20 to the position shifted from the position of positioning unit 13 by a predetermined distance in a predetermined direction. Thus, it is possible to match the center of optical receiver 22 in the photodiode 20 with the center of first surface lens 14, after the photodiode 20 is connected to the conductive plate 30.

A concave portion is formed in a substantially-circular shape on the upper surface of basement 10 supporting the conductive plate 30, which continues to the opening portion 31 of conductive plate 30. The bottom area of this concave portion is formed in a convex shape protruding upwardly to configure a first surface lens 14 at the bottom area. As described above, the position of positioning unit 13 on the transparency maintaining unit 10 is precisely determined in reference to the center of first surface lens 14, and the center of first surface lens 13 substantially matches to the center of optical receiver 22 in the photodiode 20 whose position is determined in reference to the positioning unit 13 and which is connected to the conductive plate 30. In addition, a second surface lens 15 is arranged on the lower surface of the basement 10, which is formed in a convex shape. The second surface lens 15 is arranged on the surface opposite to the upper surface of basement 10 on which the first surface lens 14 is arranged, and it is configured that the center of second surface lens 15 matches to the center of first surface lens 14 to a maximum extent.

The OSA 1 includes the basement 10, peripheral wall 12, positioning portion 13, first surface lens 14 and second surface lens 15 that are configured integrally using transparent synthetic resin. For example, the integral configuration can be implemented by so-called injection molding that is a method of putting the conductive plate 30 previously formed in an arbitrary shape into the mold, pouring transparent liquid resin into the mold and then allowing to cure the transparent resin. When the basement 10 is made of the transparent synthetic resin, the photodiode 20 connected to the conductive plate 30 can receive the light coming from the outside through the second surface lens 15, the transparent basement 10, the first surface lens 14 and the opening portion 31 of conductive plate 30. Furthermore, it is possible to select the synthetic resin configuring the basement 10 and the like, without considering the heat resistance of photodiode 20. Therefore, it is possible to select and utilize the synthetic resin that has precision molding ability and high resistance to environment change, such as temperature change.

The cylindrical portion 50 of OSA 1 is formed in a cylindrical shape, and is connected to the lower surface of the basement 10, to surround the second surface lens 15 arranged on the lower surface of basement 10. The cylindrical portion 50 includes the lower side section whose inner diameter is enlarged stepwisely, i.e., in which the inner diameter of upper section is smaller than the inner diameter of lower section. The upper section includes said smaller inner diameter that is equal to or a little larger than the diameter of second surface lens 15, and the lower section includes said larger inner diameter that is substantially equal to the diameter of optical fiber 9 and includes a fitting portion 51 for fitting the optical fiber 9 therein.

Plural and round rod-like connection pins 52 are arranged on the upper surface of cylindrical portion 50. The plural connection pins 52 are arranged to be equally spaced away from each other in the circumferential direction for the surface of cylindrical portion 50. Plural connection holes 18 are arranged on the lower surface of basement 10, in which the connection pins 52 are inserted for connecting the cylindrical portion 50. The position of connection pin 52 in the cylindrical portion 50 and the position of connection hole 18 in the basement 10 are precisely determined to match the center of cylindrical portion 50 to the center of second surface lens 15 when the connection pins 52 are inserted into the connection holes 18 and the cylindrical portion 50 is connected to the basement 10. The cylindrical portion 50 may be made of synthetic resin, or other materials, such as metal or wood. Although the cylindrical portion 50 may be connected only by the connection pins 52 inserted into the connection holes 18, an adhesive or the like may additionally be utilized for strongly connecting the cylindrical portion 50.

The position of connection pin 52 and the position of connection hole 18 are precisely determined to substantially match the center of cylindrical portion 50 with the center of second surface lens 15 when the connection pins 52 are inserted into the connection holes 18 to connect the cylindrical portion 50 to the lower surface of basement 10. In addition, the position of fitting portion 51 in the cylindrical portion 50 is precisely determined to match the center of cylindrical portion 50 with the center of optical fiber 9 when the optical fiber 9 is fit into the fitting portion 51 of cylindrical portion 50. Therefore, it is possible to match the center of second surface lens 15 and the center of optical fiber 9. Furthermore, when the center of first surface lens 14 substantially matches to the center of second surface lens 15, it is configured to substantially match the center of optical receiver 22 in the photodiode 20, the center of first surface lens 14, the center of second surface lens 15 and the center of optical fiber 9 with one another. Therefore, it is possible to make the photodiode 20 precisely receive the light emitted from the optical fiber 9.

In addition, the OSA 1 includes a cover 40 that is attached to the upper end of peripheral wall 12 arranged on the upper surface side of basement 10 and thus seals the recess portion 12a. The cover 40 is formed in a substantially-square plate shape in a plain view similar to the basement 10, and is attached to the upper end of peripheral wall 12 with a connecting method, for example, utilizing ultrasonic welding or adhesive. The cover 40 may be transparent or non-transparent, and may be formed with materials same as or different from those of basement 10, peripheral wall 12 and the like. Gas, such as nitrogen gas or dry air, may be injected into the recess portion 12a, when the cover 40 is attached. Alternatively, the inside of recess portion 12a may be configured to be vacuum.

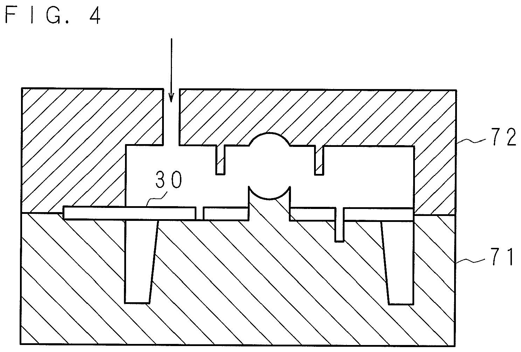

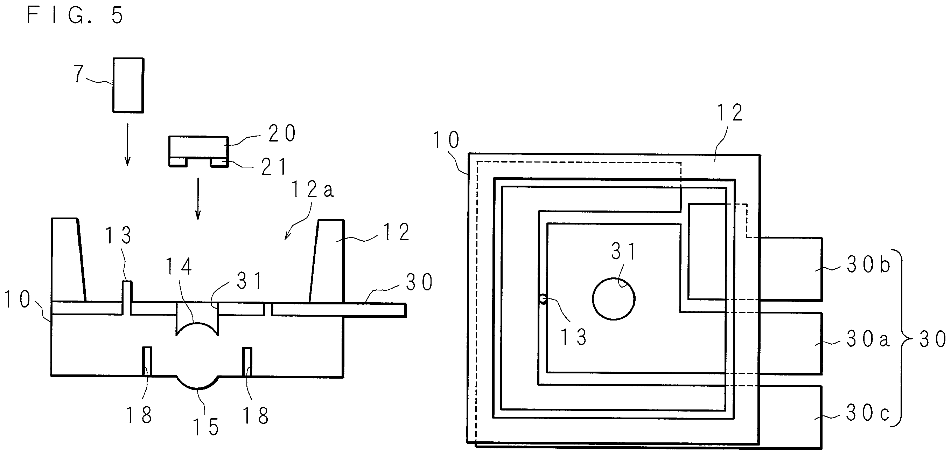

FIGs. 4-8 are schematic views explaining a method for manufacturing the optical communication module according to the present invention. The manufacturing process of OSA 1 is illustrated in the time-series figures from FIG. 4 to FIG. 8. In each of FIGs 5-7, a cross-sectional side view of OSA 1 is illustrated at the left side and a plain view (of upper surface) is illustrated at the right side. In the manufacturing process of OSA 1 according to the present invention, the basement 10 is formed by injection molding with transparent synthetic resin (see FIG. 4). A first mold 71 and second mold 72 are utilized in this resin molding processing.

The first mold 71 includes a concavity and convexity to form the upper surface of basement 10 (note: FIG. 4 is illustrated upside down), peripheral wall 12, positioning unit 13, first surface lens 14 and the like in the OSA 1. The second mold 72 includes a concavity and convexity to form the lower surface of basement 10, second surface lens 15, connection holes 18 and the like in the OSA 1. For example, the conductive plate 30 has been previously manufactured by processing the metal plate into a predetermined shape. Such a conductive plate 30 is put into the first mold 71, the second mold 72 is aligned with the first mold 71 after adjusting the positions of first mold 71 and second mold 72, and then transparent liquid synthetic resin is poured into the space configured by the concavities and convexities of first mold 71 and second mold 72. It is possible to integrally form the basement 10, peripheral wall 12, positioning unit 13, first surface lens 14, second surface lens 15, connection holes 18 and the like by curing the poured synthetic resin. It is preferred to precisely adjust the positions of first mold 71 and second mold 72 to a maximum extent for matching the center of first surface lens 14 with the center of second surface lens 15, in this processing.

Then, the position of positioning unit 13 is confirmed by capturing the image of basement 10 from the upper surface side using the camera 7 or the like, the position of photodiode 20 is determined to be the position predetermined in accordance with the confirmed position, and the electric terminal portion 21 of photodiode 20 is connected to the conductive plate 30 (see FIG. 5). Thus, the center of optical receiver 22 included in the photodiode 20 is configured to precisely match with the center of first surface lens 14.

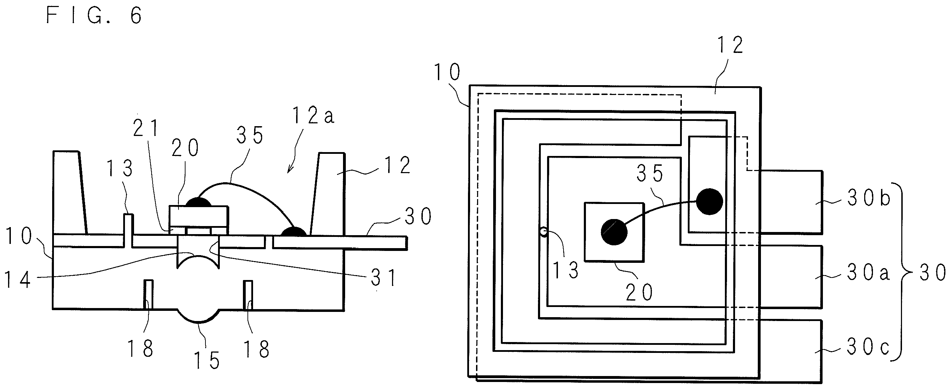

Then, the electric terminal arranged on the upper surface of photodiode 20 is connected with the wire 35 to the conductive plate 30 (30b) fixed to the basement 10 (see FIG. 6). Thus, the photodiode 20 is electrically connected to the conductive plates 30a, 30b, and the communication apparatus including the OSA 1 can detect the reception of optical signals when detecting the voltage applied between the conductive plate 30a and the conductive plate 30b.

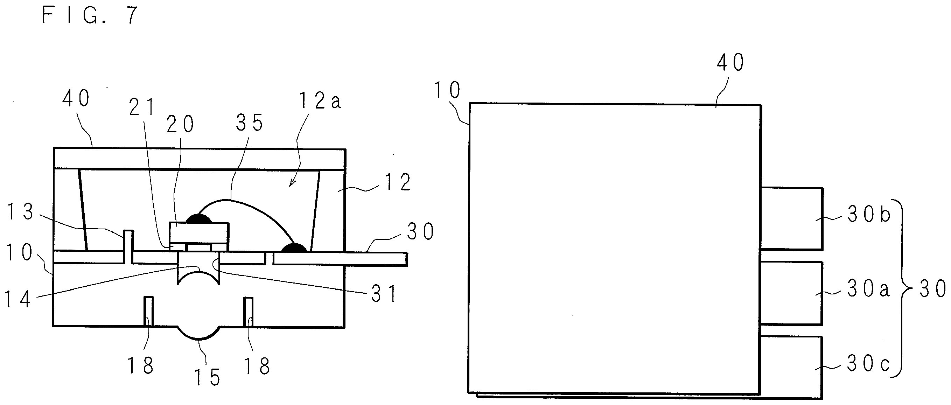

Then, the cover 40 is attached to the upper end of peripheral wall 12 with a connecting method, for example, by utilizing ultrasonic welding or adhesive, to seal the recess portion 12a accommodating the photodiode 20 (see FIG. 7). Thus, the photodiode 20 is isolated from the outside. Gas may be injected into the recess portion 12a before the cover 40 is attached to the peripheral wall 12.

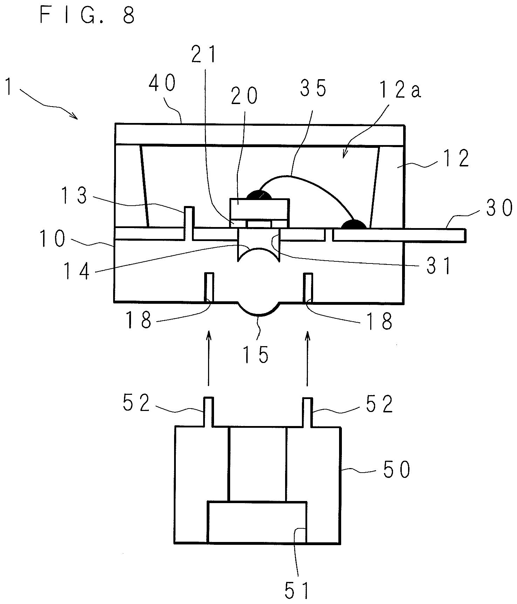

Then, the cylindrical portion 50 formed separately and previously is connected to the basement 10, with the connection pins 52 inserted into the connection holes 18 arranged on the lower surface of basement 10 (see FIG. 8). The connection pins 52 may be inserted into the connection holes 18 to fix the cylindrical portion 50 to the basement 10, after adhesive is applied to the connection pins 52, connection holes 18, the upper surface of cylindrical portion 50, the lower surface of basement 10 and the like.

These processing can manufacture the OSA 1. For the OSA 1 according to the present invention, it is possible without considering the heat resistance of photodiode 20 to select the transparent synthetic resin utilized for configuring the basement 10, peripheral wall 12 and the like, because the photodiode 20 whose position is determined is connected to the conductive plate 30 and is sealed by the cover after the basement 10, peripheral wall 12 and the like are integrally formed with transparent synthetic resin. Therefore, it is possible to select the synthetic resin that has the precise forming ability and to enhance the ability for precisely forming the basement 10, peripheral wall 12 and the like.

The injection molding requires plural molds, such as the first mold 71 and second mold 72 shown in FIG. 4. While the first mold 71 is aligned with the second mold 72 after the positions are adjusted, a mismatch may be caused between the positions of these molds, i.e., the upper surface of basement 10 may not match with the lower surface of basement 10. It is expected that the OSA 1 according to the present invention can prevent the precision for the optical communication from being reduced, even in the case that the upper surface of basement 10 does not match with the lower surface of basement 10 because of the positional mismatch of molds.

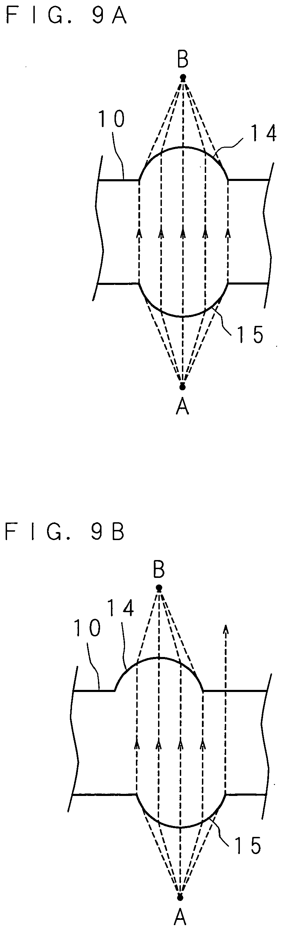

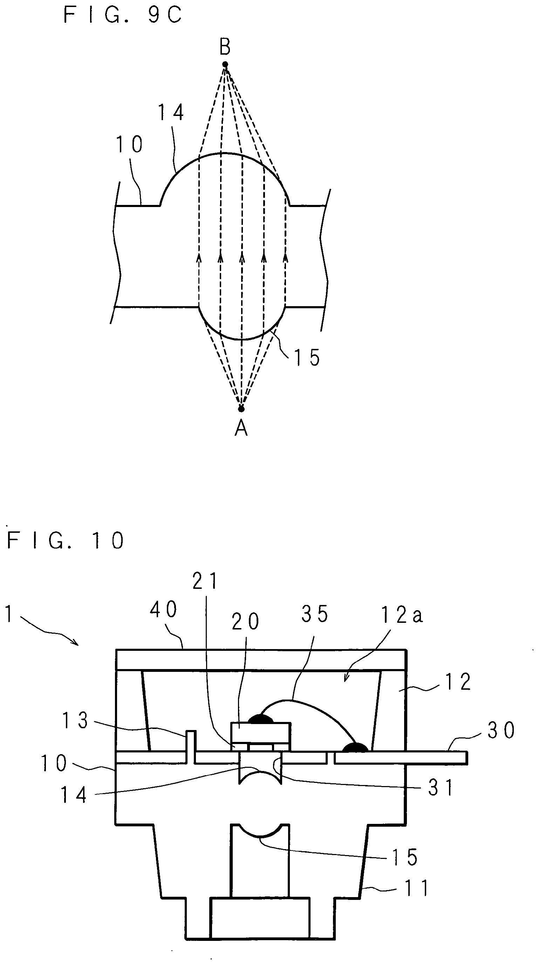

FIG. 9A to FIG. 9C are schematic views for explaining configurations of first surface lens 14 and second surface lens 15 included in the optical communication module according to the present invention, and only the basement 10, first surface 14 and second surface 15 are shown for schematically illustrate their configurations. In these figures, the point "A" represents the light emitting end of optical fiber 9, and the point "B" represents the optical receiver 22 of photodiode 20. FIG. 9A illustrates the case that the center of first surface lens 14 matches with the center of second surface lens 15. FIG. 9B and FIG. 9C illustrates the cases that a mismatch is caused between the center of first surface lens 14 and the center of second surface lens 15, i.e., the first surface lens 14 does not match with the second surface lens 15.

The light emitted from the optical fiber 9 diffuses from the light emitting end (point A) within a predetermined diffusion range and reaches the second surface lens 15. The convex surface shape of second surface lens 15 is determined to convert the light emitted from the optical fiber 9 into substantially-parallel light, in consideration of the distance to the light emitting end of optical fiber 9. Thus, the light emitted from the optical fiber 9 is converted into the substantially-parallel light by the second surface lens 15, passes through the transparent basement 10, and then reaches the first surface lens 14. The convex surface shape of first surface lens 14 is determined to focus the substantially-parallel light passing through the basement 10 into the optical receiver 22 (point B) of photodiode 20, in consideration of the distance to the optical receiver 22.

When the center of first surface lens 14 matches to the center of second surface lens 15 (see FIG. 9A), the light coming from the optical fiber 9 to the second surface 15 is converted into the substantially-parallel light by the second surface lens 15, passes through the basement 10, and then reaches the first surface lens 14. The light at the first surface lens 14 is focused into the optical receiver 22 of photodiode 20.

When the center of first surface lens 14 does not match to the center of second surface lens 15 (see FIG. 9B), the light coming from the optical fiber 9 to the second surface 15 is converted into the substantially-parallel light by the second surface lens 15, passes through the basement 10, and then reaches the first surface lens 14. The light arriving at the first surface lens 14 is focused into the optical receiver 22 of photodiode 20.

In short, the light emitted from the optical fiber 9 is converted into the substantially-parallel light by the second surface lens 15 and passes through the basement 10, regardless of whether or not the center of first surface lens 14 matches to the center of second surface lens 15. Thus, the light arriving at the first surface lens 14 is focused into the optical receiver 22 of photodiode 20. Hence, the OSA 1 according to the present invention can surely focus the light emitted from the optical fiber 9 into the optical receiver 22 of photodiode 20, even in the case that the center of first surface lens 14 does not match to the center of second surface lens 15. Therefore, it is possible to prevent reduction in optical communication performance.

When the center of first surface lens 14 does not match the center of second surface lens 15 in the case that first surface lens 14 has a size equal to or smaller than the second surface lens 15, a part of the substantially-parallel light converted by the second surface lens 15 passes to the outside of basement 10 without reaching to the first surface lens 14. Thus, it may cause reduction in the amount of light focused into the optical receiver 22 of photodiode 20. However, when there is only a small amount of mismatch between the first surface lens 14 and second surface lens 15, it is possible to perform the optical communication with enough precision because it does not cause the shift of destination to which the light is focused by the first surface lens 14 toward the optical receiver 22.

In order to prevent the reduction in the amout of light, the fist surface lens 14 directing light to the optical receiver 22 can be configured larger than the second surface lens 15 to which the light is directed from the optical fiber 9 (see FIG. 9C). Thus, the light converted into the substantially-parallel light by the second surface lens 15 can surely reach the first surface lens 14. Therefore, the first surface lens 14 can focus all the light directed to the second surface lens 15 into the optical receiver 22.

In the case that the OSA 1 includes a laser diode, instead of the photodiode 20, and performs the transmission of optical signals, the second surface lens 15 may be configured larger than the first surface lens 14, in order to prevent the reduction in the amount of light caused by the mismatch between center positions for the first surface lens 14 and second surface lens 15. In other words, the surface lens at the side where light comes from the light source may be configured smaller than the other surface lens at the other side which focuses parallel light coming through the basement 10 and emits the focused light.

In the OSA 1 described above, the first surface lens 14 is arranged at one side of the transparent basement 10, the photodiode 20 is connected to the conductive plate 30 after the position of photodiode 20 is determined in reference to the positioning unit 13 arranged at one side of basement 10, the second surface lens 15 is arranged at said the other side of basement 10, and the cylindrical portion 50 is utilized for determining the position of optical fiber 9 relative to the second surface lens 15. Thus, the optical receiver 22 of photodiode 20 can receive the light, emitted from the optical fiber 9, through the cylindrical portion 50, second surface lens 15, basement 10, first surface lens 14, and opening portion 31 of conductive plate 30. Furthermore, the second surface lens 15 can convert the light emitted from the optical fiber 9 into the substantially-parallel light, and the first surface lens 14 can focus the substantially-parallel light into the optical receiver 22. Therefore, it is possible to prevent the reduction in optical communication performance, because the optical receiver 22 of photodiode 20 can surely receive the light, even in the case that the injection molding causes the mismatch between first mold 71 and second mold 72 and the center of first surface lens 14 does not match to the center of second surface lens 15.

In addition, it is possible to utilize an easy and low cost method for sealing the photodiode 20, because the cover 40 is attached to the recess portion 12a to seal the photodiode 20 and thus precise connection of cover 40 is not required. In addition, it is possible to perform easy and precise connection of photodiode 20 to the conductive plate 30 based on the positioning unit 13, because the positioning unit 13 is arranged on the upper surface of basement 10 to protrude within the recess portion 12a and is formed precisely and integrally with the basement 10.

In addition, the cylindrical portion 50 is arranged on the lower surface of basement 10 to surround the second surface lens 15, and the optical fiber 9 is fit to the tip section of cylindrical portion 50. Thus, the cylindrical portion 50 can be connected precisely to the basement 10. Hence, the positions of second surface lens 15 and optical fiber 9 can be determined easily and precisely, and the second surface lens 15 can surely convert the light emitted from the optical fiber 9 into the substantially-parallel light. Therefore, it is possible to surely focus the light into the optical receiver 22 of photodiode 20 by the first surface lens 14.

In this embodiment, the OSA 1 is illustrated to be the photoelectric conversion device that includes the photodiode 20 and receives light. However, the present invention is not limited to the illustration. The photoelectric conversion device may include a laser diode and may emit light. In this embodiment, the OSA 1 is further illustrated to include one photoelectric conversion device within the recess portion 12a. However, the present invention is not limited to the latter illustration. The OSA 1 may include plural photoelectric conversion devices. For example, the OSA 1 may include both the photodiode and laser diode, as the photoelectric conversion devices. Thus, the OSA 1 may emit light and receive light to perform the transmission of optical signals.

The configuration of conductive plate 30 (30a-30c) in FIG. 3 is an example, and the present invention is not limited to this example. In addition, although it is illustrated to connect the electric terminal on the upper surface of photodiode 20 to the conductive plate 30 with the wire 35, the present invention is not limited to the illustration. When plural connectors 21 are arranged on the lower surface of photodiode 20, such connection may be made without the wire 35 .

In addition, although it is illustrated that the opening portion 31 is formed as the optical pass portion in the conductive plate 30 and the optical receiver 22 of photodiode 20 receives light through the opening portion 31, the present invention is not limited to the illustration. For example, a notch, groove or the like may be formed on the conductive plate 30, as the optical pass portion, for receiving light. Alternatively, in the case that plural connectors 21 are arranged on the lower surface of photodiode 20 and each connector is connected to a different conductive plate 30, the optical receiver 22 of photodiode 20 may receive light through the gap between conductive plates 30, the gap being used as the optical pass portion. Alternatively, in the case that a part or whole of the formed conductive plate 30 is transparent, such a transparent portion may be utilized as the optical pass portion for passing the light to the photodiode 20.

In addition, although it is illustrated that the positioning unit 13 is arranged on the upper surface of basement 10 and the position of photodiode 20 is determined in reference to the positioning unit 13, the present invention is not limited to the illustration. The OSA 1 may be provided without the positioning unit 13, and the position of photodiode 20 may be determined in reference to another portion on the upper surface of basement 10. Alternatively, the center of first surface lens 14 may be recognized from the picture captured by the camera 7, and the position of photodiode 20 may be determined directly in reference to the recognized center.

In addition, although it is illustrated that the recess portion 12a is configured by the peripheral wall 12 arranged on the upper surface of basement 10 and the photodiode 20 is sealed by the cover 40 sealing the recess portion 12a, the present invention is not limited to the illustration. Another method may be utilized for the sealing. For example, the photodiode 20 may be sealed with resin. In addition, although it is illustrated that only the photodiode 20 is arranged inside the recess portion 12a, the present invention is not limited to the illustration. Other electrical circuit components may also be arranged inside the recess portion 12a, which include a resistance, capacitor, coil, integrated circuit (IC) and/or the like and configure the electrical circuit.

### (Variation)

Although it is illustrated that the separately formed cylindrical portion 50 is connected to the basement 10 by inserting the connection pins 52 into the connection holes 18, the present invention is not limited to the illustration. The cylindrical portion may be formed integrally with the basement 10. FIG. 10 is a schematic cross section view showing a configuration of optical communication module in the variation according to the present invention. In the OSA1 of this variation, the cylindrical portion 11 is arranged to protrude on the lower surface of basement 10 and to surround the second surface lens 15, and is formed with transparent synthetic resin to become integral with the basement 10. The center of cylindrical portion 11 approximately matches to the center of second surface lens 15.

For example, a concave portion for forming the cylindrical portion 11 is prepared to the second mold 72 shown in the injection molding processing of FIG. 4, in order to implement the integral configuration made of transparent synthetic resin in the OSA 1 of this variation. Thus, the manufacturing process of OSA 1 does not require the step for connecting the separately formed cylindrical portion 50 to the basement 10. Therefore, it is possible to simplify the manufacturing process. Furthermore, the cylindrical portion 11 can be precisely formed integral with the basement 10. Therefore, it is possible to more precisely match the center of second surface lens 15 to the center of optical fiber 9 by fitting the optical fiber 9 to the cylindrical portion 11.

### (Embodiment 2)

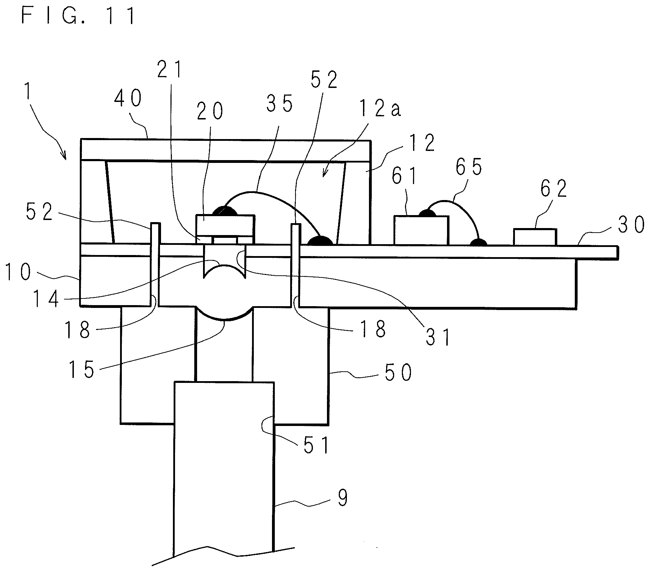

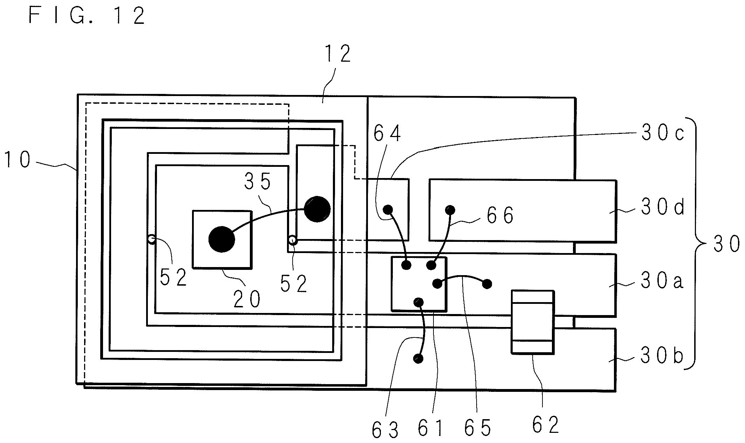

FIG. 11 is a schematic cross section view showing a configuration of optical communication module in Embodiment 2 according to the present invention. FIG. 12 is a schematic flat view showing a configuration of optical communication module without the cover 40 (described later) in the embodiment 2 according to the present invention

The numeral "1" in figures represents the OSA corresponding to the optical communication module according to the present invention, which contains the sealed photodiode (photoelectric conversion device) 20 and the electrical circuit configured with the amplifier IC 61, capacitor 62 and the like. The optical fiber (communication line) 9 is connected to the OSA 1. The OSA 1 is a device for utilizing the photodiode 20 to receive light emitted from another device through the optical fiber 9, converting an optical signal into an electrical signal and outputting the electrical signal to perform an optical communication.

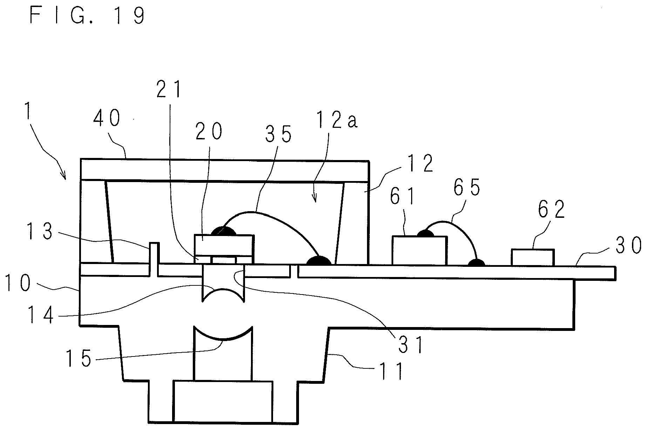

The OSA 1 includes the basement (transparency maintaining unit) 10 that is formed in a substantially-rectangular plate shape in a plain view, the photodiode 20 is connected to one surface of basement 10 (the surface at the upper side in FIG. 11; simply called "upper surface" hereinafter), and the cylindrical portion 50 is arranged on the other surface (the surface at the lower side in FIG. 19; simply called "lower surface" hereinafter) for connecting the optical fiber 9. The peripheral wall 12 is arranged to stand vertically near one side in the longitudinal direction and on the upper surface of basement 10, and is formed in a substantially-square shape in a plain view. The recess portion 12a is formed by the upper surface and peripheral wall 12 of basement 10, to accommodate the photodiode 20.

The photodiode 20 is an approximately-square-shaped plate in a plain view. The optical receiver (photoelectric conversion unit) 22 is formed at the substantial center on the lower surface of photodiode 20, which converts an optical signal into an electrical signal in response to detection of light. One or more connectors 21 are arranged around the optical receiver 22. The connector 21 is an electric terminal for inputting and outputting the electrical signal of photodiode 20, and for connecting the photodiode 20 to the conductive plate 30 with soft solder, conductive adhesive or the like. the OSA 1 including the photodiode 20 shown in FIG. 2A.

The conductive plate 30 is made of metal and buried in the basement 10 of OSA 1, but one surface of conductive plate 30 is exposed from the upper surface of basement 10. The connector 21 of photodiode 20 is connected with soft solder, conductive adhesive or the like to the portion of conductive plate 30 exposed within the recess portion 12a, and/or the electric terminal of photodiode 20 arranged on the upper surface or the like is connected with the wire 35 to the portion of conductive plate 30 exposed within the recess portion 12a. In addition, the electrical circuit components (such as the amplifier IC 61 and capacitor 62) are connected directly with the soft solder, conductive adhesive or the like and/or wire to the portion of conductive plate 30 exposed outside the recess portion 12a. The conductive plate 30 is utilized for transmitting electrical signals between the photodiode 20 and an electrical circuit component, and for transmitting electrical signals with the outside of OSA 1. In other words, the conductive plate 30 serves as the wiring that connects the circuit components with each other in the reception circuit including the photodiode 20.

The OSA 1 in the embodiment 2 includes four conductive plates 30a-30d (see FIG. 12). The first conductive plate 30a includes a substantially-square portion that is located at the center of recess portion 12a on the basement 10, and an extension portion that contacts the substantially-square portion and is extending in the longitudinal direction of basement 10 from the side surface of basement 10 to the outside of the basement 10. The opening portion 31 is formed as the optical pass portion for passing light at the substantial center of substantially-square portion. After the first conductive plate 30a is fixed to the basement 10, the opening portion 31 is located at the substantial center of recess portion 12a on the basement 10 in a plain view. The diameter of opening portion 31 is shorter than one side of lower surface of the photodiode 20, and longer than the diameter of optical receiver 22 included in the photodiode 20. The connector 21 of photodiode 20 is connected to the periphery of opening portion 31 in the first conductive plate 30 with the soft soldier or conductive adhesive. In addition, the amplifier IC 61 is fixed with adhesive or the like to the portion of first conductive plate 30a exposed outside the recess portion 12a. The amplifier IC 61 includes four electric terminals, and one of the electric terminals is connected through the wire 65 to the first conductive plate 30a.

The second conductive plate 30b is arranged to surround the first conductive plate 30a, and one end portion thereof is extending from the side surface of basement 10 to the outside. The capacitor 62 is an electrical circuit component including two electric terminals, one of which is connected to the first conductive plate 30a and the other of which is connected to the second conductive plate 30b. The second conductive plate 30b is connected through the wire 63 to the electric terminal arranged on the upper surface of amplifier IC 61.

The third conductive plate 30c is formed in a substantially-"L" shape, and is aligned in parallel with the first conductive plate 30a. One end portion of third conductive plate 30c is exposed outside the recess portion 12a on the basement 10, and the other end portion is exposed inside the recess portion 12a. The third conductive plate 30c is connected through the wire 35 to the electric terminal arranged on the upper surface of photodiode 20 inside the recess portion 12a, and connected through the wire 64 to the electric terminal arranged on the upper surface of amplifier IC 61 outside the recess portion 12a.

The fourth conductive plate 30d is formed in a substantially-rectangular shape, and is aligned in parallel with the conductive plate 30c in the longitudinal direction of basement 10. One end portion of fourth conductive plate 30d is exposed from the side surface of basement 10 to the outside. The fourth conductive plate 30d is connected through the wire 66 to the electric terminal arranged on the upper surface of amplifier IC 61. The extension portions of conductive plates 30a, 30b, 30d extending from the side surface of basement 10 are utilized as electric terminals for connecting the OSA 1, for example, to the circuit board of communication apparatus.

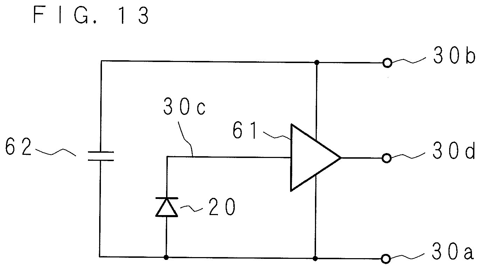

FIG. 13 is a circuit diagram showing an example of reception circuit configured with the conductive plates 30a-30d of OSA 1. The OSA 1 in the embodiment 2 includes the circuit receiving optical signals by containing the photodiode 20 and another electrical circuit component (the amplifier IC 61 and capacitor 62) that are properly connected to the conductive plates 30a-30d. The photodiode 20 includes an anode of electric terminal (connector 21) on the lower surface, and a cathode of electric terminal on the upper surface. The position of photodiode 20 is precisely determined to make the optical receiver 22 receive light from the opening portion 31, and is connected to the first conductive plate 30a by the connector 21.

The amplifier IC 61 includes four electric terminals (input terminal, output terminal, high-side power supply terminal, and low-side power supply terminal) on the upper surface, and no electric terminal on the lower surface. The lower surface of amplifier IC 61 is fixed to the first conductive plate 30a with soft soldier, conductive adhesive or the like. The high-side power supply terminal arranged on the upper surface of amplifier IC 61 is connected through the wire 63 to the second conductive plate 30b. The input terminal of amplifier IC 61 is connected through the wire 64 to the third conductive plate 30c, i.e., electrically connected to the cathode of electric terminal included in the photodiode 20. The low-side power supply terminal of amplifier IC 61 is connected through the wire 65 to the first conductive plate 30a. The output terminal of amplifier IC 61 is connected through the wire 66 to the fourth conductive plate 30d.

As described above, the capacitor 62 is arranged to cross over the first conductive plate 30a and second conductive plate 30b. The electric terminal at the one end of capacitor 62 is connected to the first conductive plate 30a and the other electric terminal at the other end of capacitor 62 is connected to the second conductive plate 30b. Thus, it is possible to configure the electrical circuit shown in FIG. 4. Therefore, it is possible to convert the optical signal received by the OSA 1 into the electrical signal and to output the electrical signal from the fourth conductive plate 30d, for example, by connecting the first conductive plate 30a to the ground potential and the second conductive plate 30b to the power supply potential.

In addition, the basement 10 and peripheral wall 12 of OSA 1 are integrally formed with transparent synthetic resin. For example, it is possible for forming the integral unit to utilize so-called injection molding, in which the conductive plate 30 is previously formed in an arbitrary shape and put into the mold and liquid transparent resin is poured and allowed to cure. In the case that the basement 10 is formed with the transparent synthetic resin, the photodiode 20 connected to the conductive plate 30 can receive light from the outside through the transparent basement 10 and the opening portion 31 of conductive plate 30. The synthetic resin utilized for configuring the basement 10 and peripheral wall 12 can be selected, regardless of heat resistance of photodiode 20 and the like. Therefore, it is possible to select the synthetic resin that has precise molding ability and tight tolerance to environment change, such as temperature change.

A concave portion is formed in a substantially-circular shape on the upper surface of basement 10 supporting the conductive plate 30. This concave portion continues to the opening portion 31 of conductive plate 30. The bottom part of this concave portion is formed in a convex shape extending upwardly. The first surface lens 14 is configured at the bottom part. In addition, the second surface lens 15 is formed in the convex shape on the lower surface of basement 10. The second surface lens 15 is arranged to be opposed to the first surface lens 14 arranged on the upper surface side of basement 10. Furthermore, it is configured that the center of second surface lens 15 matches to the center of first surface lens 14 to a maximum extent.

In addition, the OSA 1 includes the cylindrical portion 50 that is formed in a cylindrical shape and protrudes from the lower surface of basement 10. The cylindrical portion 50 is formed independently from the basement 10, and connected to the lower surface of basement 10 to surround the second surface lens 15 arranged on the lower surface of basement 10. The cylindrical portion 50 includes the lower side section whose inner diameter is enlarged stepwisely, i.e., in which the inner diameter of upper section is smaller than the inner diameter of lower section. The upper section includes said smaller inner diameter that is equal to or a little larger than the diameter of second surface lens 15. The lower section includes said larger inner diameter that is substantially equal to the diameter of optical fiber 9 and includes a fitting portion 51 for fitting the optical fiber 9 therein.

Plural and round rod-like connection pins 52 are arranged on the upper surface of cylindrical portion 50. The plural connection pins 52 are arranged to be equally spaced away from each other in the circumferential direction for the surface of cylindrical portion 50. Plural connection holes 18 are arranged to vertically penetrate the basement 10, in which the connection pins 52 are inserted for supporting the cylindrical portion 50. The position of connection pin 52 in the cylindrical portion 50 and the position of connection hole 18 in the basement 10 are precisely determined to match the center of cylindrical portion 50 to the center of second surface lens 15 when the connection pins 52 are inserted into the connection holes 18 and the cylindrical portion 50 is connected to the basement 10. The cylindrical portion 50 may be made of synthetic resin, or other materials, such as metal or wood. Although the cylindrical portion 50 is connected by the connection pins 52 inserted into the connection holes 18, adhesive may additionally be utilized for more strongly connecting the cylindrical portion 50.

Because the position of connection pin 52 and the position of connection hole 18 are precisely determined, the center of cylindrical portion 50 will match to the center of second surface lens 15 when the connection pin 52 is inserted into the connection hole 18 and the cylindrical portion 50 is connected to the lower surface of basement 10. Furthermore, because the fitting portion 51 of cylindrical portion 50 is precisely formed, the center of cylindrical portion 50 will match to the center of optical fiber 9 when the optical fiber 9 is fit to the fitting portion 51 of cylindrical portion 50. Therefore, it is possible to substantially match the center of second surface lens 15 with the center of optical fiber 9.

The OSA 1 includes the cover 40, for sealing the recess portion 12a, which is attached to the upper end of peripheral wall 12 arranged on the upper surface side of basement 10. The plain view of cover 40 shows a substantially-square plate shape, similar to peripheral wall 12, and the cover 40 is attached to the upper end of peripheral wall 12 with a connecting method, for example, utilizing ultrasonic welding or adhesive. The cover 40 may be transparent or non-transparent, and may be made of material same as or different from the basement 10, peripheral wall 12 and the like. Nitrogen gas or dry air may be applied into the recess portion 12a when the cover 40 is attached, or alternatively, the recess portion 12a is vacuumed.

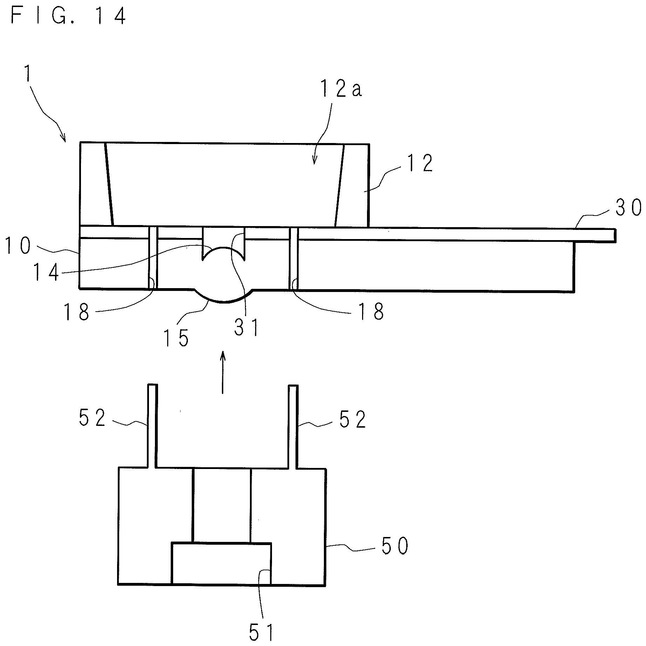

FIG. 14 to FIG. 18 are schematic views explaining a method for manufacturing the optical communication module according to the present invention. The manufacturing process of OSA 1 is illustrated in the time-series figures from FIG. 14 to FIG. 18. In the manufacturing process of OSA 1 according to the present invention, the conductive plate 30 is formed in an arbitrary shape, for example, by machining a metal plate. The formed conductive plate 30 is put into the mold for the injection molding, liquid transparent resin is poured into the mold and is allowed to cure, and thus, the basement 10, peripheral wall 12, first surface lens 14, second surface lens 15 and the like are formed integrally (this processing is not shown in figures). This processing makes the center of first surface lens 14 precisely match to the center of opening portion 31 in the conductive plate 30 arranged on the basement 10. In addition, the cover 40 and cylindrical portion 50 are previously formed with a method such as resin molding.

Then, the cylindrical portion 50 formed separately and previously is connected to the lower surface of basement 10 (See FIG. 14). The connection of cylindrical portion 50 can be implemented only with the connection pin 52 that is arranged on the upper surface of cylindrical portion 50 and is inserted into the connection hole 18 in the basement 10, and it is not required to determine the position of cylindrical portion 50 with respect to the basement 10. The connection pin 52 may be inserted into the connection hole 18 to fix the cylindrical portion 50 to the basement 10, after adhesive is applied to the connection pin 52, connection hole 18, the upper surface of cylindrical portion 50, the lower surface of basement 10 and the like.

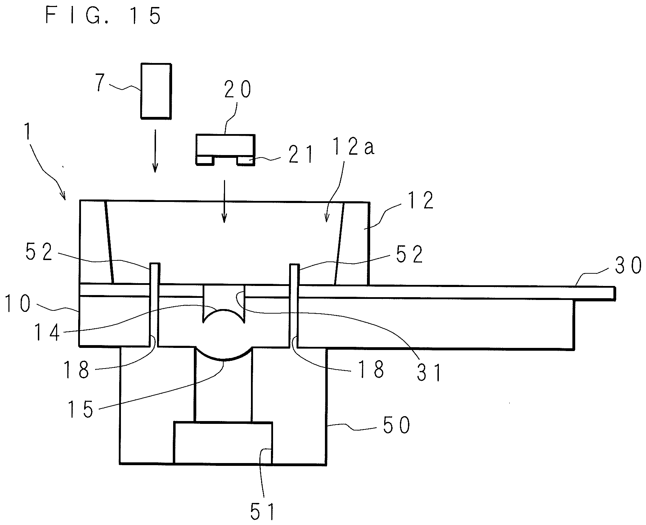

Then, for example, the camera 7 is utilized to capture the image from the upper surface side of basement 10 for recognizing a reference position of basement 10. The position of photodiode 20 is determined to be the predetermined position based on this reference position, and the electric terminal portion 21 of photodiode 20 is connected to the conductive plate 30 (see FIG. 15). Therefore, the center of optical receiver 22 in the photodiode 20 precisely matches to the center of first surface lens 14.

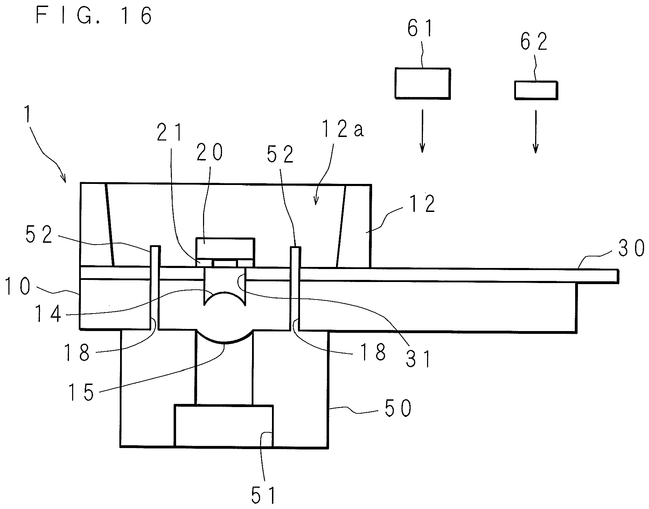

Then, electrical circuit components, such as the amplifier IC 61 and capacitor 62, are mounted on the region of conductive plate 30 that is exposed to the upper surface of basement 10 and is outside the recess portion 12a (See FIG. 16). Soft solder, conductive adhesive or the like may be utilized for connecting the electric terminal of electrical circuit component to the conductive plate 30. Non-conductive adhesive may be utilized for connecting a part other than the electrical terminal (such as the case for the electrical circuit component) to the conductive plate 30.

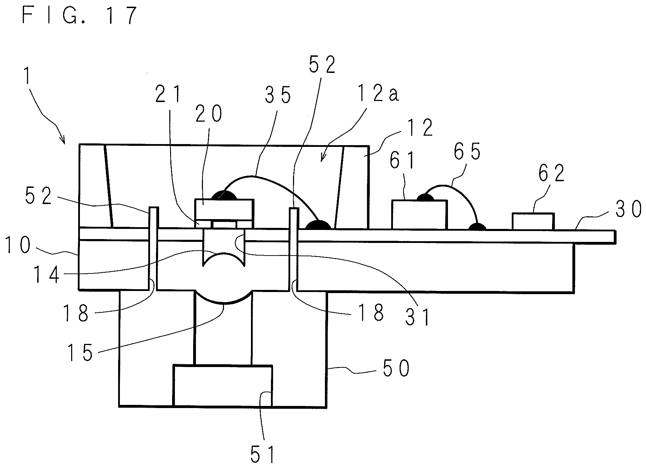

Then, wire 35 is utilized to connect the electric terminal arranged on the upper surface of photodiode 20 and the conductive plate 30c arranged on the basement 10, and wires 63-66 are utilized to connect four electric terminals arranged on the upper surface of amplifier IC 61 and the conductive plates 30a-30d arranged on the basement 10 (see FIG. 17). Thus, the photodiode 20, amplifier IC 61 and capacitor 62 are electrically connected as shown in the circuit diagram of FIG. 13. The communication apparatus including the OSA 1 can receive the optical signal based on the signals output from the fourth conductive plate 30d, as the first conductive plate 30a is connected to the ground potential and the second conductive plate 30b is connected to the power supply potential.

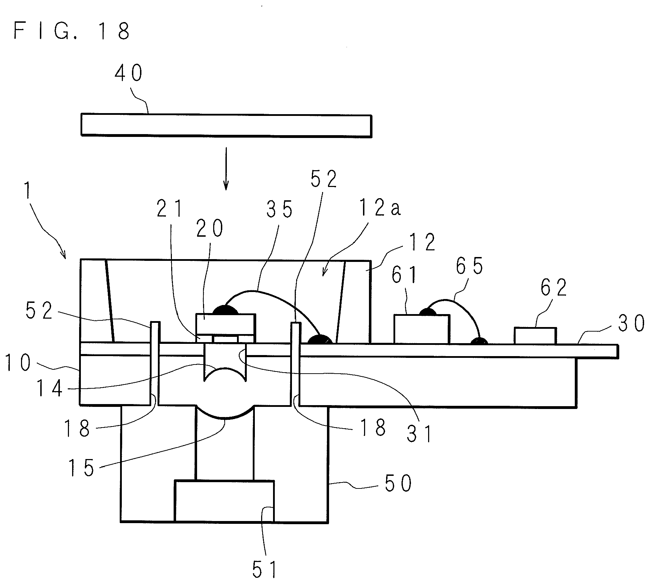

Then, the cover 40 is attached to the upper end of peripheral wall 12 with a connecting method, for example, utilizing ultrasonic welding or adhesive (See FIG. 18). Thus, the photodiode 20 is isolated from the outside. Gas may be injected into the recess portion 12a before the cover 40 is connected to the peripheral wall 12.

As described above, the OSA 1 includes the photodiode 20 arranged inside the recess portion 12a of basement 10 and includes the electrical circuit components (such as the amplifier IC 61 and capacitor 62) arranged outside the recess portion 12a, and includes plural conductive plates 30a-30d and wires 35, 63-66 that are utilized for electrically connecting the photodiode 20 and electrical circuit components. Therefore, OSA 1 can include plural electrical circuit components, without the need for the circuit board and the like, and the OSA 1 can utilize these electrical components to configure the reception circuit and the like. The configurations of present invention can reduce the size of optical communication module including the electrical circuits (such as the reception circuit) greater than the optical communication module including the circuit board for the reception circuit. Furthermore, the configurations of present invention can reduce the number of parts because not requiring to include the circuit board and the peripheral parts for the circuit board. Therefore, it is possible to reduce the size of communication apparatus and the like including the OSA 1 according to the present invention, to simplify the process for manufacturing the OSA 1, and to reduce the cost of OSA 1.

The position of photodiode 20 is determined to connect the photodiode 20 to the conductive plate 30 exposed inside the recess portion 12a of basement 10, and to perform the transmission of optical signals through the opening portion 31 of conductive plate 30 and the transparent basement 10. The cover 40 is utilized for sealing after the photodiode 20 is connected. Hence, the position of photodiode 20 in the OSA 1 can be precisely adjusted after the basement 10 is formed, and then the photodiode 20 can be connected to the conductive plate 30. Therefore, the sealing with the cover 40 does not affect the connection position of photodiode 20. It is possible to implement precise forming of the basement 10 because the synthetic resin utilized for forming the basement 10 can be selected without considering the heat resistance ability of photodiode 20 and the like. Furthermore, it is possible to precisely adjust the positions of first surface lens 14 and the like, because the position of photodiode 20 can be precisely determined in accordance with the basement 10 that is precisely formed. Moreover, it is possible to enhance the optical communication performance of the OSA 1.

In addition, it is not required to implement precise connection of cover 20, because the photodiode 20 is sealed by the cover 40 attached to the recess portion 12a. Therefore, the photodiode 20 can be sealed with a simple method and with low cost.

In addition, the cylindrical portion 50 can be precisely connected to the basement 10 with the connection pin 52 and connection hole 18, because the cylindrical portion 50 is arranged on the lower surface of basement 10 to surround the second surface lens 15 and the optical fiber 9 is fitted to the fitting portion 51 of cylindrical portion 50. Hence, it is possible to easily and precisely determine the positions of second surface lens 15 and optical fiber 9. Therefore, it is possible to enhance the performance of optical communication with utilizing the OSA 1.

Although the OSA 1 in this embodiment is illustrated to include the photodiode 20 as the photoelectric conversion device for receiving light, the present invention is not limited to this illustration. The OSA 1 may include a laser diode as the photoelectric conversion device for emitting light. In addition, although the OSA 1 in this embodiment is illustrated to include one photoelectric conversion device in the recess portion 12a, the present invention is not limited to this illustration. The OSA 1 may include plural photoelectric conversion devices. In such a case that two photoelectric conversion devices (photodiode and laser diode) are included in the latter illustration, the OSA can emit and receive light and can perform the transmission of the optical signal.

In addition, the conductive plate 30 (30a-30d) shown in FIG. 12 is an example, and the present invention is not limited to this example. The circuit configuration shown in FIG. 13 is an example, and the present invention is not limited to this example. The electrical circuit components included in the OSA 1 are not limited to the amplifier IC 61 and capacitor 62. The other electrical circuit components may be included and various electrical circuits can be configured.

In addition, it is illustrated that the center of opening portion 31 in the conductive plate 30 matches to the center of optical receiver 22 in the photodiode 20. However, it is not necessary that the center of optical receiver 22 matches to the center of opening portion 31, in the case that the center of optical receiver 22 substantially matches to the center of first surface lens 14. In addition, although it is illustrated that the wire 35 is used for connecting the electric terminal arranged on the upper surface of photodiode 20 and the conductive plate 30, the present invention is not limited to the illustration. The connection with wire 35 may not be employed in the case that plural connectors 21 are arranged on the lower surface of photodiode 20.

Although the conductive plate 30 is illustrated to include the opening portion 31 as the optical pass portion and the optical receiver 22 of photodiode 20 is illustrated to receive light through the opening portion 31, the present invention is not limited to the illustration. For example, a notch, groove or the like may be formed as the optical pass portion on the conductive plate 30 for receiving light. For example, when plural connectors 21 are provided and each connector is connected to a different conductive plate 30, a gap between conductive plates 30 may be utilized as the optical pass portion through which the optical receiver 22 of photodiode 20 receives light through the gap. For example, in the case that the transparent electric conductor can be utilized for forming a part or whole of the conductive plate 30, this transparent portion may be utilized as the optical pass portion for passing the light to the photodiode 20.

### (Variation 1)

Although it is illustrated that the cylindrical portion 50 is formed separately and the connection pin 51 is inserted into the connection hole 18 for connecting the cylindrical portion 50 to the basement 10, the present invention is not limited to the illustration. The cylindrical portion may be formed integrally with the basement 10. FIG. 19 is a schematic cross section view showing a configuration of the optical communication module in Variation 1 of Embodiment 2 according to the present invention. The OSA 1 in this variation 1 includes the cylindrical portion 11 protruding on the lower surface of basement 10 and surrounding the second surface lens 15. This cylindrical portion 11 is made of transparent synthetic resin and formed integrally with the basement 10. The center of cylindrical portion 11 substantially matches to the center of second surface lens 15.

The round rod-shaped positioning unit 13 is arranged to protrude inside the recess portion 12a on the upper surface of basement 10. The positioning unit 13 is utilized as the reference position for determining the position of photodiode 20 when the photodiode 20 is connected to the conductive plate 30 in the recess portion 12a. The position of positioning unit 13 to the center of opening portion 31 in the conductive plate 30 on the basement 10 or to the center of first surface lens 14 is precisely determined. The manufacturing machine for connecting the photodiode 20 to the conductive plate 30 may connect the photodiode 20 at the position far from the positioning unit 13 by a predetermined distance in a predetermined direction, for example, in reference to the position of positioning unit 13 recognized by the image captured from the upper surface of basement 10 by the camera.

Thus, it is not required to connect the separated cylindrical portion 50 to the basement 10 in the process of manufacturing the OSA 1. Therefore, it is possible to simplify the manufacturing process. Furthermore, the cylindrical portion 11 can be precisely formed integrally with the basement 10. Therefore, it is possible to precisely match the center of second surface lens 15 to the center of optical fiber 9 by fitting the optical fiber 9 in the cylindrical portion 11.

### (Variation 2)

In the method of manufacturing the optical communication module described above, the photodiode 20 is connected to the conductive plate 30 inside the recess portion 12a (see FIG. 15) and then the electrical circuit components (such as the amplifier IC 61 and capacitor 62) are connected to the conductive plate 30 outside the recess portion 12a with soft solder, conductive adhesive or the like (see FIG. 16), as shown in FIG 14 to FIG. 18. However, the present invention is not limited to such an embodiment. The method of manufacturing the optical communication module in Variation 2, the photodiode 20 is connected to the conductive plate 30 inside the recess portion 12a, and then the cover 40 is attached to the peripheral wall 12 without connecting the electrical circuit components to the conductive plate 30 outside the recess portion 12a.

After the cover 40 is attached, the electrical circuit component is connected to the conductive plate 30 outside the recess portion 12a. At that time, the electrical circuit component is connected with the solder reflow method, i.e., by printing solder including flux onto the conductive plate 30; arranging the electrical circuit components on the solder; and sweating the solder.

Because the wire bonding with the wire 35 is performed on the photodiode 20, the flux utilized in the solder reflow method is not preferred for the photodiode 20. However, recess portion 12a is sealed by the attachment of cover 40 in the manufacturing method of variation 2, and thus the electrical circuit components can be connected to the conductive plate 30 outside the recess portion 12a with the solder reflow method.

### (Embodiment 3)

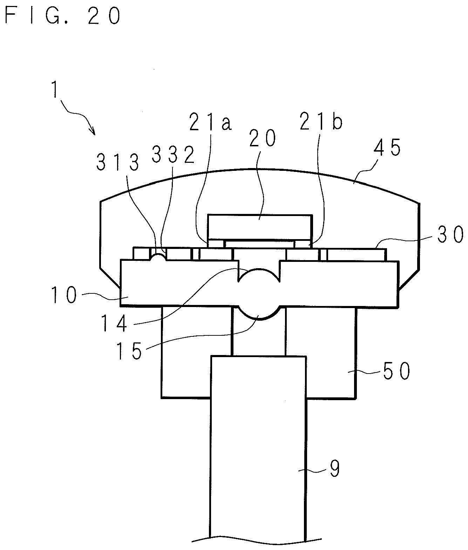

FIG. 20 is a schematic cross section view showing a configuration of the optical communication module in the embodiment 3 according to the present invention. The numeral "1" in figures represents the OSA in which the photodiode (photoelectric conversion device) 20 is packaged. The OSA 1 corresponds to an optical communication module according to the present invention. The optical fiber 9 is connected to the OSA 1. The OSA 1 is a device for utilizing the photodiode 20 to receive light emitted from another device through the optical fiber 9, converting an optical signal into an electrical signal and outputting the electrical signal to perform an optical communication.

The OSA 1 includes the plate-shaped basement (transparency maintaining unit) 10 that is approximately square in plain view. The metal conductive plate 30 is arranged on one surface of basement 10 (upper surface in FIG. 20; said one surface is simply called the "upper surface", hereinafter), the photodiode 20 is connected to the conductive plate 30. The sealing unit 45 is arranged on the upper surface, in which the conductive plate 30 and photodiode 20 is sealed with the synthetic resin. In addition, the basement 10 is made of transparent resin, and the first surface lens 14 is formed integrally on the upper surface of basement 10. The second surface lens 15 is integrally formed on the other surface of basement 10 (lower surface in FIG. 20; said other surface is simply called the "lower surface", hereinafter). The cylindrical portion 50 is arranged to protrude on the lower surface around the second surface lens 15 for fitting the optical fiber 9 therein.

The photodiode 20 is an approximately-square-shaped plate in a plain view. The optical receiver 22 is formed at a substantial center on the lower surface of photodiode 20, which converts an optical signal into an electrical signal in response to detection of light. One or more connectors are arranged around the optical receiver 22. The connector is an electric terminal for inputting and outputting the electrical signal of photodiode 20, and for connecting the photodiode 20 to the conductive plate 30 with soft solder, conductive adhesive or the like. It is described below in the context of OSA 1 including the photodiode 20 in which two connectors 21a, 21b are arranged on the lower surface as shown in FIG. 2B. However, the photodiode 20 included in the OSA 1 may alternatively be configured as shown in FIG. 2A or FIG. 2C, or the like.

The metal conductive plate 30 is arranged on the basement 10 of OSA 1. The conductive plate 30 is formed in an arbitrary pattern through, for example, cutting or etching a metal plate. The connectors 21a, 21b of photodiode 20 are connected to the upper surface of conductive plate 30 with soft solder, conductive adhesive or the like, and the lower surface of conductive plate 30 touches the upper surface of basement 10. The conductive plate 30 is utilized for performing the transmission of electrical signals between the photodiode 20 and the outside, and corresponds to the wiring connecting the circuit components with each other in the reception circuit utilizing the photodiode 20.

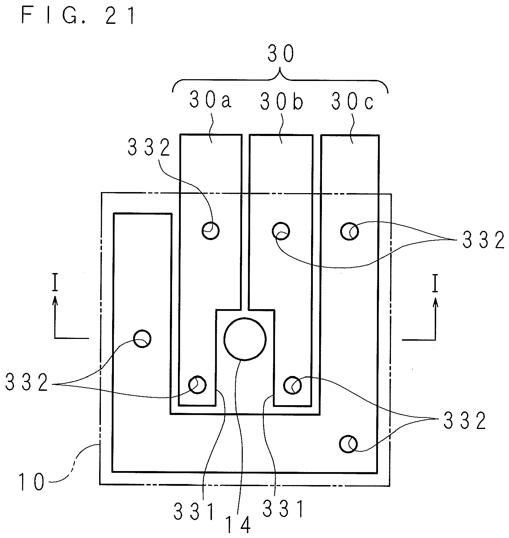

FIG. 21 is a schematic flat view showing a configuration of conductive plate included by the optical communication module of embodiment 3 according to the present invention. FIG. 21 shows the outline of basement 10 illustrated by the two-dot chain line which is overlaid on the upper surface of conductive plate 30. In the example of the figure, the OSA 1 includes three conductive plates 30a-30c. The first conductive plate 30a and second conductive plate 30b are connected to the connectors 21a, 21b of photodiode 20, respectively. The first conductive plate 30a and second conductive plate 30b are configured in a substantially-rectangular shape in a plain view, whose one end in the longitudinal direction is extending to the outside of basement 10 and the other end is positioned at the center of basement 10. In addition, the first surface lens 14 is arranged at the center of lower surface on the basement 10, and a notch 331 is formed on each of said other ends of first conductive plate 30a and second conductive plate 30b. The notch 331 is configured not to cover the first surface lens 14. In other words, the first conductive plate 30a and second conductive plate 30b are arranged to sandwich the first surface lens 14 in a plain view, and the gap between the first conductive plate 30a and second conductive plate 30b caused by the notch 331 works as the optical pass portion for passing light to the upper and lower surface side of conductive plate 30.

The third conductive plate 30c is formed in a substantially-"U" shape, and arranged along the periphery of basement 10 to surround the first conductive plate 30a and second conductive plate 30b. One end portion of third conductive plate 30c is extending to the outside of basement 10. The third conductive plate 30c is utilized for shielding the OSA 1 and is connected, for example to the ground potential. The portions of conductive plates 30a-30c extending from the basement 10 are utilized as electric terminals for connecting the OSA 1, for example, to the circuit board of communication apparatus.

In addition, plural positioning holes 332 are respectively formed at proper positions on the conductive plates 30 (first conductive plate 30a-third conductive plate 30c). Each positioning hole 332 is formed in a substantially-circular shape, and penetrates the upper and lower surfaces of conductive plate 30. On the other hand, plural positioning projections 313 are formed on the upper surface of basement 10. Each positioning projection 313 is formed in a substantially-circular shape in a plain view, and can be put into the positioning hole 332 of conductive plate 30.

The position where each positioning projection 313 is formed on the upper surface of basement 10 is precisely determined to define the position for arranging the conductive plate 30. Therefore, the conductive plate 30 is precisely arranged as shown in FIG. 21 without adjusting the position of conductive plate 30, when the conductive plate 30 is put on the upper surface of basement 10 such that the positioning hole 332 of conductive plate 30 fits to the positioning projection 313 of basement 10 in the process manufacturing the OSA 1.

The photodiode 20 is connected to the conductive plate 30 arranged on the upper surface of basement 10. The connection position of photodiode 20 may be determined in reference to the position of positioning projection 313 or conductive plate 30 arranged on the upper surface of basement 10, or may be determined in reference to a mark put on the lower surface of basement 10 which can be recognized through the transparent basement 10, first surface lens 14 and second surface lens 15.

When the OSA 1 described above has been actually created with the conductive plate 30 whose thickness is about 100 µm, width is not less than 200 µm and distance between each of plural conductive plate 30 (30a-30c) is not less than 200 µm, the position of conductive plate 30 has been shifted in reference to the basement 10 by a distance within only ± 50 µm. In addition, when the OSA 1 described above has been actually created with the photodiode 20 in which each size of connectors 21a, 21b is not less than 100 µm, the positional shift for the photodiode 20 has been within ± 10 µm. Each of these values is an example, and it is possible to further enhance the ability of implementing the precise position of arranged conductive plate 30 and the precise position of connected photodiode 20.

The basement 10, positioning projection 313, first surface lens 14, second surface lens 15 and the like of OSA 1 are formed integrally with transparent synthetic resin. For example, the integral formation can be performed, for example, with so-called an injection molding method, i.e., pouring liquid transparent resin into the mold previously manufactured and allowing to cure the resin. Because the basement 10 is made of transparent synthetic resin, the photodiode 20 connected to the conductive plate 30 can receive light incident from the first surface lens 14 and second surface lens 15 through the transparent basement 10 and through the gap between the first conductive plate 30a and second conductive plate 30b. In addition, the synthetic resin for the basement 10 can be selected regardless of the heat resistance ability of photodiode 20 and the like. Therefore, it is possible to select the synthetic resin that has the high ability of precise forming and that shows high resistance to deformation in response to environment change, such as temperature change.

The conductive plate 30 arranged on the basement 10 and the photodiode 20 connected to conductive plate 30 are sealed with the synthetic resin. The sealing unit 45 is arranged on the upper surface of basement 10, which seals the photodiode 20 and conductive plate 30. The sealing unit 45 may be made of transparent or non-transparent synthetic resin different from the synthetic resin for basement 10. The synthetic resin for sealing unit 45 should be selected in consideration of heat resistance for the photodiode 20 and the like, although precise forming ability is not required.

A concave portion is formed in a substantially-circular shape on the upper surface of basement 10. This concave portion continues to the opening portion 31 of conductive plate 30. The bottom part of this concave portion is formed in a convex shape extending upwardly, including the first surface lens 14 arranged thereat. The second surface lens 15 is configured in a convex shape on the lower surface of basement 10. The second surface lens 15 is arranged to be opposed to the first surface lens 14 arranged on the upper surface side of basement 10. Furthermore, it is configured that the center of second surface lens 15 matches to the center of first surface lens 14 to a maximum extent. The position of photodiode 20 is determined on the conductive plate 30 to match the center of first surface lens 14 with the center of optical receiver 22, and then the photodiode 20 is connected to the conductive plate 30.

The cylindrical portion 50 arranged on the lower surface of basement 50 is formed in a cylindrical shape, and is manufactured separately from the basement 10. The cylindrical portion 50 may be made of synthetic resin, metal or another material. The position of cylindrical portion 50 is determined to match the center of cylindrical portion 50 with the center of second surface lens 15, and then the cylindrical portion 50 is connected to the lower surface of basement 10 with a connecting method, such as utilizing welding or adhesive. The cylindrical portion 50 has one inner diameter at one side connected to the basement 10 (the upper side in FIG. 1) which is a little larger than the diameter of second surface lens 15, and has the other inner diameter at the other side (the lower side in FIG. 1) which is larger than the one inner diameter. Thus, the optical fiber 9 for optical communication can be fit to the lower side of cylindrical portion 50. When the optical fiber 9 is fit to the cylindrical portion 50, the end surface of optical fiber 9 is opposed to the second surface lens 15 and the center of optical fiber 9 matches to the center of second surface lens 15.

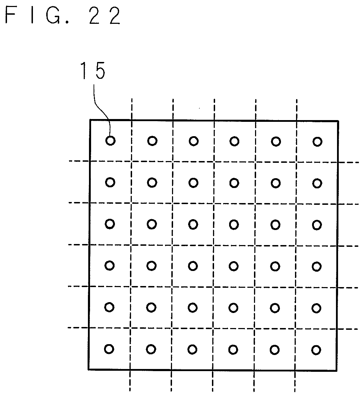

FIG. 22 to FIG. 27 are schematic views explaining a method for manufacturing the optical communication module in the embodiment 3 according to the present invention. The manufacturing process of OSA 1 is illustrated in the time-series figures from FIG. 22 to FIG. 27. In the OSA 1 according to the present invention, the basement 10 can be manufactured separately from the conductive plate 30, cylindrical portion 50 and the like. Thus, plural basements 10 can be formed with injection molding method at the same time in the manufacturing process. In the process of manufacturing the OSA 1 according to the present invention, the liquid transparent resin is firstly poured into the pre-manufactured mold (not shown in figures) and then is allowed to cure, for manufacturing a plate configured with plural basements 10 that are connected in 6 x 6 matrix arrangement (see FIG. 22). In this step, the first surface lens 14, second surface lens 15 and projection 313 of each basement 10 are also formed.

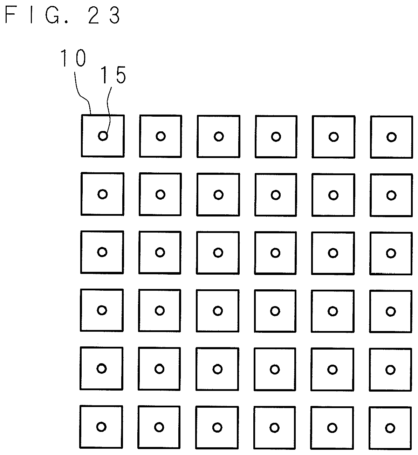

Then, the dice cutting is performed on the plate configured with plural basements 10 connected in the matrix arrangement. For example, the plate can be cut on the broken lines shown in FIG. 22. The performed dice cutting generates 36 separated basements 10 (see FIG. 23). The precision cutting of basement 10 is not required in this step.

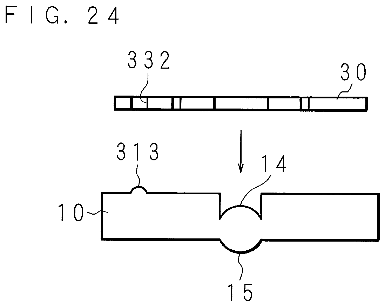

Then, the conductive plate 30 is arranged on the upper surface of separated basement 10 (see FIG. 24). The conductive plate 30 is formed in an arbitrary shape from a metal plate on which the dice cutting or etching is previously performed. When the conductive plate 30 is arranged on the upper surface of basement 10, the position of conductive plate 30 is determined to make the plural positioning holes 332 formed on the conductive plate 30 fit to the corresponding positioning projections 313 on the basement 10. Thus, the position of conductive plate 30 can be determined properly on the basement 10. The conductive plate 30 may be fixed with adhesive or the like to the basement 10 in this step.

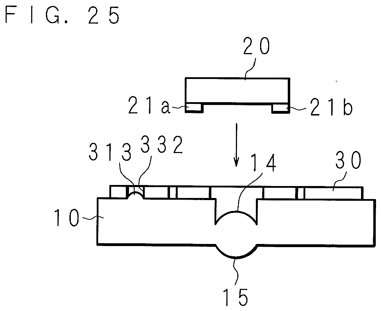

Then, the photodiode 20 is connected to the conductive plate 30 arranged on the basement 10 (see FIG. 25). At that time, the position of basement 10 is captured from the upper side by the camera and the like, to confirm the proper position of positioning projection 313 or conductive plate 30. In reference to the confirmed position, the position of photodiode 20 is determined, and then the connectors 21a, 21b of photodiode 20 are connected to the conductive plate 30 with the soft solder, conductive adhesive or the like. Thus, the center of optical receiver 22 in the photodiode 20 precisely matches to the center of first surface lens 14 on the basement 10.

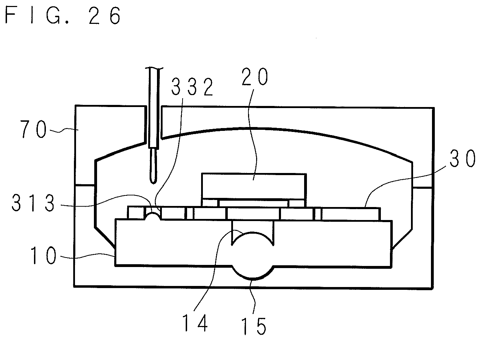

Then, the basement 10, photodiode 20 and conductive plate 30 are put into the pre-manufactured mold 70, the liquid synthetic resin is poured into the mold 70, and the liquid synthetic resin is allowed to cure, for forming the sealing unit 45 (see FIG. 26). The formed sealing unit 45 should be able to cover the upper surface side of basement 10 and to prevent at least the photodiode 20 and conductive plate 30 from moving in reference to the basement 10. In the case that the conductive plate 30 is fixed to the basement 10 with adhesive or the like, the sealing unit 45 may cover only the photodiode 20.

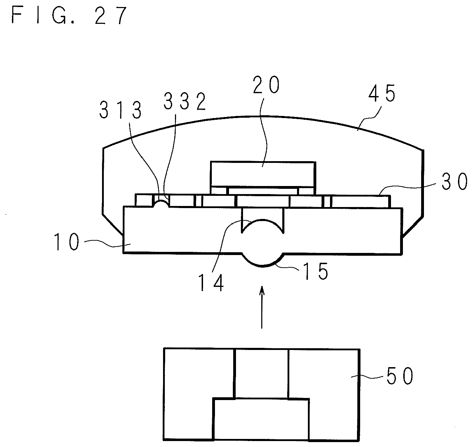

Then, the cylindrical portion 50 is fixed to the lower surface of basement 10 to manufacture the OSA 1 (see FIG. 27). When the cylindrical portion 50 is fixed, the position of cylindrical portion 50 is determined to match the center of cylindrical portion 50 with the center of second surface lens 15 arranged on the lower surface of basement 10. The lower surface of basement 10 and upper surface of cylindrical portion 50 may be configured with a projection and concave portion, similarly to the positioning projection 313 of basement 10 and positioning hole 332 of conductive plate 30, for determining the position of cylindrical portion 50. In this configuration, it is possible to facilitate the positioning of cylindrical portion 50.

The OSA 1 described above includes: the conductive plate 30 arranged on the upper surface of transparent basement 10; the photodiode 20 connected to the conductive plate 30; and the sealing unit 45 sealing the photodiode 20 and conductive plate 30. Therefore, it is possible to separate the step of forming the basement 10 with resin from the step of arranging the conductive plate 30 and photodiode 20 on the basement 10. Hence, plural basements 10 can be integrally formed with transparent resin, and then separated from each other to manufacture each basement 10. Therefore, it is possible to reduce the cost for manufacturing the basement 10, in comparison with the case that each basement 10 is formed with resin one by one.

In addition, it is possible to easily and precisely arrange the conductive plate 30 to each basement 10, because the positioning projection 313 is provided to the basement 10 and the positioning hole 332 is provided to the conductive plate 30 to determine the position of conductive plate 30 in reference to the basement 10 by fitting the positioning projection 313 in the positioning hole 332. In addition, it is possible to independently manufacture each basement 10 with resin as described above, because the first surface lens 14 and second surface lens 15 are formed integrally with the basement 10, and the photodiode 20 is configured to perform the transmission of optical signals through the gap (optical pass portion) between the second surface lens 15, basement 10, first surface lens 14 and conductive plate 30. Hence, it is possible to form with resin the basement 10 having precise forming ability, regardless of the heat resistance ability and the like of photodiode 20. Therefore, it is possible to precisely form the first surface lens 14 and second surface lens 15 together with the basement 10, realizing precise manufacturing of OSA 1 and reduction in the cost for OSA 1.

Although the OSA 1 in this embodiment is illustrated to include the photodiode 20 as the photoelectric conversion device for receiving light, the present invention is not limited to the illustration. The OSA 1 may be alternatively configured to include a laser diode like the vertical cavity surface emitting laser (VICSEL) as the photoelectric conversion device for emitting light. In addition, although the OSA 1 is illustrated to include one photoelectric conversion device, the present invention is not limited to the illustration. The OSA 1 may be alternatively configured to include plural photoelectric conversion devices. In the case that the OSA 1 includes both the photodiode and laser diode as the photoelectric conversion device, the OSA 1 can emit and receive light and can perform the transmission of optical signals.

Although the photodiode 20 and conductive plate 30 are illustrated to be sealed with synthetic resin and to be fixed to the basement 10, the present invention is not limited to the illustration. The photodiode 20 and conductive plate 30 may be sealed and fixed with another method. In addition, the configuration of conductive plate 30 (30a-30c) shown in FIG. 21 is an example, and the present invention is not limited to this example. In addition, the conductive plate 30 is illustrated to include the positioning hole 332 penetrating the conductive plate 30, the present invention is not limited to the illustration. Alternatively, the conductive plate 30 may include a concave portion for positional determination which does not penetrate the conductive plate 30.

### (Variation 1)

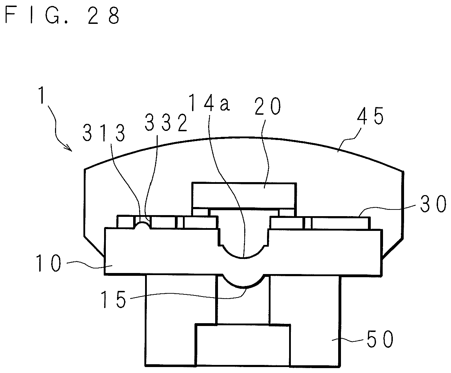

Although the OSA 1 described above is illustrated to include the first surface lens 14 in a convex shape extending upward integrally formed on the upper surface of basement 10, the present invention is not limited to the illustration. FIG. 28 is a schematic cross section view showing a configuration of optical communication module in Variation 1 of Embodiment 3 according to the present invention. The OSA 1 in the variation 1 includes the first surface lens 14a arranged on the upper surface of basement 10, and formed in a concave shape whose center is falling downward.

In the configuration that the synthetic resin flows into the gap between the optical receiver 22 of photodiode 20 and the first surface lens 14a when the photodiode 20 is sealed with the synthetic resin and the sealing unit 45 is formed, the sealing unit 45 should be made of transparent synthetic resin. Depending on the refraction indices of transparent synthetic resin forming the first surface lens 14a and of transparent synthetic resin forming the sealing unit 45, the concave first surface lens 14a may be arranged on the upper surface of basement 10, instead of the convex first surface lens 14. Alternatively, another lens having more complex surface construction may be arranged on the upper surface of basement 10.

### (Variation 2)

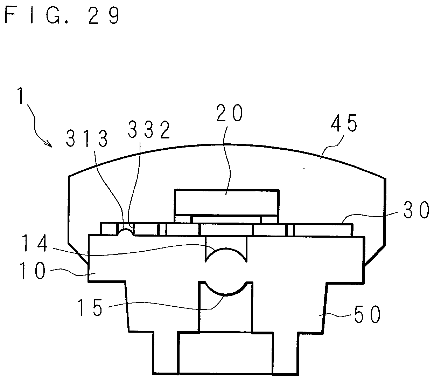

FIG. 29 is a schematic cross section view showing a configuration of optical communication module in Variation 2 of Embodiment 3 according to the present invention. Although the OSA 1 in the embodiment described above includes separately-formed cylindrical portion 50 fixed to the basement 10, the OSA 1 in the variation 2 is configured to include the cylindrical portion 50 integrally formed with the basement 10. This configuration can simplify the manufacturing process of OSA 1 and reduce the manufacturing cost for OSA 1, because the cylindrical portion 50 can be manufactured together with the basement 10 when many basements 10 are integrally formed with resin (See FIG. 22). In addition, it is possible to precisely match the center of second surface lens 15 to the center of optical fiber 9 fit to the cylindrical portion 50, because the cylindrical portion 50 can be formed precisely in reference to the second surface lens 15. Therefore, it is possible enhance the communication performance of OSA 1.

### EXPLANATION OF ITEM NUMBERS

- 1: OSA (optical communication module)
- 7: camera
- 9: optical fiber (communication line)
- 10: basement (transparency maintaining unit)
- 11: cylindrical portion
- 12: peripheral wall
- 12a: recess portion
- 13: positioning unit
- 14, 14a: first surface lens
- 15: second surface lens
- 18: connection hole
- 20: photodiode (photoelectric conversion device)
- 21, 21a-21d: connector
- 22: optical receiver (photoelectric conversion unit)
- 30, 30a-30d: conductive plate (electric conductor)
- 31: opening portion (optical pass portion)
- 35: wire
- 40: cover
- 45: sealing unit (sealing means)
- 50: cylindrical portion
- 51: fitting portion
- 52: connection pin
- 61: amplifier IC (electrical circuit component)
- 62: capacitor (electrical circuit component)
- 63-66: wire
- 71: first mold
- 72: second mold
- 313: positioning projection (projection)
- 331: notch
- 332: positioning hole (hole portion)

## Claims

1. An optical communication module, comprising:
a photoelectric conversion device (20) that is provided with a photoelectric conversion unit (22) and a connector (21, 21a-21d) on one surface of the photoelectric conversion device (20), wherein the photoelectric conversion unit (22) performs a photoelectric conversion from an optical signal to an electrical signal or from an electrical signal to an optical signal with receiving or emitting light, and the connector (21, 21a-21d) connects the photoelectric conversion device (20) to another device;
an electric conductor (30, 30a-30d) that is connected to the connector (21, 21a-21d) of the photoelectric conversion device (20) and is provided with an optical pass portion (31) for passing light toward the photoelectric conversion unit (22) of the connected photoelectric conversion device (20);
a transparency maintaining unit (10) that passes light, and supports the electric conductor (30, 30a-30d), and whose portion connected to the photoelectric conversion device (20) is exposed;
a lens (14) integrally formed on an upper surface of the transparency maintaining unit (10);
another lens (15) integrally formed on a lower surface of the transparency maintaining unit (10); and
a cylindrical portion (50) that protrudes to surround the another lens (15); wherein
the photoelectric conversion device (20) is connected to an exposed portion of the electric conductor (30, 30a-30d),
the photoelectric conversion unit (22) is opposed to one of the lenses (14, 15) formed on the transparency maintaining unit (10),
a transmission of an optical signal is performed through the lenses (14, 15) formed on the transparency maintaining unit (10) and the optical pass portion (31) of the electric conductor (30, 30a-30d),
the cylindrical portion (50) internally fits a communication line (9) for performing an optical communication,
the photoelectric conversion device (20) performs a transmission of an optical signal through an inside of the cylindrical portion (50), the lenses (14, 15) of the transparency maintaining unit (10), and the optical pass portion (31) of the electric conductor (30, 30a-30d), and
a center of the lens (14) substantially matches to a center of the photoelectric conversion unit (22) of the photoelectric device (20), and a center of the another lens (15) substantially matches to a center of the cylindrical portion (50).

2. An optical communication module according to Claim 1, wherein
the lens (14) of the transparency maintaining unit (10) is formed integrally by a mold different from another mold for integrally forming said another lens (15) of the transparency maintaining unit (10).

3. An optical communication module according to Claim 1 or 2, further comprising:
a cover (40) that seals a recess portion (12a) which is arranged on the transparency maintaining unit (10) for accommodating the photoelectric conversion device (20).

4. An optical communication module according to any one of Claims 1-3, further comprising:
an electrical circuit component (61, 62) that is connected to the exposed portion of the electric conductor (30, 30a-30d).

5. An optical communication module according to Claim 4, further comprising:
another of the electric conductor (30, 30a-30d), wherein
the photoelectric conversion device (20) and the electrical circuit component (61, 62) are electrically connected through the electric conductor (30, 30a-30d) and said another electric conductor (30, 30a-30d), and configure an electrical circuit for performing a photoelectric conversion.

6. An optical communication module according to Claim 4 or 5, wherein
the electrical circuit component (61, 62) is connected to the electric conductor (30, 30a-30d) with a soft solder including a flux.

7. An optical communication module according to any one of Claims 1-6, further comprising:
a positioning unit (13) that is arranged to protrude on the transparency maintaining unit (10) for determining a position of the photoelectric conversion device (20).

8. An optical communication module according to any one of Claims 1-7, wherein
the transparency maintaining unit (10) comprises a projection (313) for determining a position of the electric conductor (30, 30a-30d), and
the electric conductor (30, 30a-30d) comprises a hole portion (332) engaged to the projection (313) of the transparency maintaining unit (10).

9. An optical communication module according to any one of Claims 1-8, wherein
a parallel light passes between the lens (14) and said another lens (15) through the transparency maintaining unit (10).

10. A method for manufacturing an optical communication module, comprising:
preparing a photoelectric conversion device (20) that is provided with a photoelectric conversion unit (22) and a connector (21, 21a-21d) on one surface of the photoelectric conversion device (20), wherein the photoelectric conversion unit (22) performs a photoelectric conversion from an optical signal to an electrical signal or from an electrical signal to an optical signal with receiving or emitting light, and the connector (21, 21a-21d) connects the photoelectric conversion device (20) to another device;
preparing an electric conductor (30, 30a-30d) that is connected to the connector (21, 21a-21d) of the photoelectric conversion device (20) and is provided with an optical pass portion (31) for passing light toward the photoelectric conversion unit (22) of the connected photoelectric conversion device (20);
preparing a cylindrical portion (50) that protrudes to surround the another lens (15) and internally fits a communication line (9) for performing an optical communication;
preparing a transparency maintaining unit (10) that passes light, and supports the electric conductor (30, 30a-30d), and whose portion connected to the photoelectric conversion device (20) is exposed;
preparing a mold for integrally forming a lens (14) and a portion of the transparency maintaining unit (10);
preparing another mold for integrally forming another lens (15) and another portion of the transparency maintaining unit (10);
determining a position of the photoelectric conversion device (20) relative to the portion of the transparency maintaining unit (10), and then connecting the connector (21, 21a-21d) to an exposed portion of the electric conductor (30, 30a-30d); and
integrally forming the transparency maintaining unit (10), the lens (14), and said another lens (15) with a transparent synthetic resin by the mold and said another mold-; wherein
the photoelectric conversion device (20) performs a transmission of an optical signal through an inside of the cylindrical portion (50), the lenses (14, 15) of the transparency maintaining unit (10), and the optical pass portion (31) of the electric conductor (30, 30a-30d), and
a center of the lens (14) substantially matches to a center of the photoelectric conversion unit (22) of the photoelectric device (20), and a center of the another lens (15) substantially matches to a center of the cylindrical portion (50).

11. A method for manufacturing an optical communication module according to Claim 10, further comprising:
arranging a positioning unit (13) protruding on the transparency maintaining unit (10); and
determining the position of the photoelectric conversion device (20) based on the positioning unit (13).

12. A method for manufacturing an optical communication module according to Claim 10 or 11, further comprising:
configuring a recess portion (12a) in the transparency maintaining unit (10) for accommodating the photoelectric conversion device (20); and
sealing the recess portion (12a) by a cover (40) after the connector (21, 21a-21d) is connected to the exposed portion of the electric conductor (30, 30a-30d).

13. A method for manufacturing an optical communication module according to Claims 10 -12, further comprising:
dicing an integrally formed complex of the transparency maintaining unit (10) to separate into plural of the transparency maintaining unit (10), for preparing the transparency maintaining unit (10); and
arranging the electric conductor (30, 30a-30d) on the separated transparency maintaining unit (10).

14. A method for manufacturing an optical communication module according to Claim 13, further comprising:
integrally forming a projection (313) on the separated each transparency maintaining unit (10); and
engaging the projection (313) to a hole portion (332) formed on the electric conductor (30, 30a-30d), to determine the position of the electric conductor (30, 30a-30d).

## Patentansprüche

1. Optisches Kommunikationsmodul mit:
einer fotoelektrischen Umwandlungsvorrichtung (20), die eine fotoelektrische Umwandlungseinheit (22) und einen Verbinder (21, 21 a-21 d) auf einer Oberfläche der fotoelektrischen Umwandlungsvorrichtung (20) umfasst, wobei die fotoelektrische Umwandlungseinheit (22) eine fotoelektrische Umwandlung von einem optischen Signal in ein elektrisches Signal oder von einem elektrischen Signal in ein optisches Signal durchführt, wobei sie Licht empfängt bzw. aussendet, und wobei der Verbinder (21, 21a-21 d) die fotoelektrische Umwandlungsvorrichtung (20) mit einer weiteren Vorrichtung verbindet;
einem elektrischen Leiter (30, 30a-30d), der mit dem Verbinder (21, 21a-21 d) der fotoelektrischen Umwandlungsvorrichtung (20) verbunden ist und einen Lichtdurchlassabschnitt (31) zum Durchlassen von Licht in Richtung der fotoelektrischen Umwandlungseinheit (22) der verbundenen fotoelektrischen Umwandlungsvorrichtung (20) umfasst;
einer Transparenzbewahrungseinheit (10), die für Licht durchlässig ist und den elektrischen Leiter (30, 30a-30d) stützt und dessen mit der fotoelektrischen Umwandlungsvorrichtung (20) verbundener Abschnitt freiliegend ist;
einer Linse (14), die Teil einer oberen Oberfläche der Transparenzbewahrungseinheit (10) ist;
einer weiteren Linse (15), die Teil einer unteren Oberfläche der Transparenzbewahrungseinheit (10) ist; und
einem zylindrischen Abschnitt (50), der so vorragt, dass er die weitere Linse (15) umgibt; wobei
die fotoelektrische Umwandlungsvorrichtung (20) mit einem freiliegenden Abschnitt des elektrischen Leiters (30, 30a-30d) verbunden ist,
die fotoelektrische Umwandlungseinheit (22) gegenüber einer der Linsen (14, 15) angeordnet ist, die Teil der Transparenzbewahrungseinheit (10) sind,
eine Übertragung eines optischen Signals durch die Linsen (14, 15), die Teil der Transparenzbewahrungseinheit (10) sind, und den Lichtdurchlassabschnitt (31) des elektrischen Leiters (30, 30a-30d durchgeführt wird,
in den zylindrischen Abschnitt (50) eine Kommunikationsleitung (9) zum Durchführen einer optischen Kommunikation eingepasst ist,
die fotoelektrische Umwandlungsvorrichtung (20) eine Übertragung eines optischen Signals durch den zylindrischen Abschnitt (50), die Linsen (14, 15) der Transparenzbewahrungseinheit (10) und den Lichtdurchlassabschnitt (31) des elektrischen Leiters (30, 30a-30d) durchführt, und
eine Mitte der Linse (14) im Wesentlichen mit einer Mitte der fotoelektrischen Umwandlungseinheit (22) der fotoelektrischen Vorrichtung (20) übereinstimmt und eine Mitte der weiteren Linse (15) im Wesentlichen mit einer Mitte des zylindrischen Abschnitts (50) übereinstimmt.

2. Optisches Kommunikationsmodul nach Anspruch 1, wobei
die Linse (14) der Transparenzbewahrungseinheit (10) durch eine Form angeformt ist, die von einer weiteren Form zum Anformen der weiteren Linse (15) der Transparenzbewahrungseinheit (10) verschieden ist.

3. Optisches Kommunikationsmodul nach Anspruch 1 oder 2, das ferner umfasst:
eine Abdeckung (40), die einen Aussparungsabschnitt (12a) verschließt, der auf der Transparenzbewahrungseinheit (10) zum Aufnehmen der fotoelektrischen Umwandlungsvorrichtung (20) angeordnet ist.

4. Optisches Kommunikationsmodul nach einem der Ansprüche 1-3, das ferner umfasst:
eine elektrische Schaltungskomponente (61, 62), die mit dem freiliegenden Abschnitt des elektrischen Leiters (30, 30a-30d) verbunden ist.

5. Optisches Kommunikationsmodul nach Anspruch 4, das ferner umfasst:
einen weiteren von dem elektrischen Leiter (30, 30a-30d), wobei
die fotoelektrische Umwandlungsvorrichtung (20) und die elektrische Schaltungskomponente (61, 62) durch den elektrischen Leiter (30, 30a-30d) und den weiteren elektrischen Leiter (30, 30a-30d) elektrisch verbunden sind und eine elektrische Schaltung zur Durchführung einer fotoelektrischen Umwandlung bilden.

6. Optisches Kommunikationsmodul nach Anspruch 4 oder 5, wobei
die elektrische Schaltungskomponente (61, 62) mit dem elektrischen Leiter (30, 30a-30d) mit einem Weichlot, das ein Flussmittel enthält, verbunden ist.

7. Optisches Kommunikationsmodul nach einem der Ansprüche 1-6, das ferner umfasst:
eine Positionierungseinheit (13) zum Bestimmen einer Position der fotoelektrischen Umwandlungsvorrichtung (20), die auf der Transparenzbewahrungseinheit (10) vorragt.

8. Optisches Kommunikationsmodul nach einem der Ansprüche 1-7, wobei
die Transparenzbewahrungseinheit (10) einen Vorsprung (313) zum Bestimmen einer Position des elektrischen Leiters (30, 30a-30d) umfasst, und
der elektrische Leiter (30, 30a-30d) einen Lochabschnitt (332) umfasst, der sich mit dem Vorsprung (313) der Transparenzbewahrungseinheit (10) in Eingriff befindet.

9. Optisches Kommunikationsmodul nach einem der Ansprüche 1-8, wobei
ein paralleles Licht zwischen der Linse (14) und der weiteren Linse (15) durch die Transparenzbewahrungseinheit (10) hindurchtritt.

10. Verfahren zum Herstellen eines optischen Kommunikationsmoduls, das umfasst:
Herstellen einer fotoelektrische Umwandlungsvorrichtung (20), die eine fotoelektrische Umwandlungseinheit (22) und einen Verbinder (21, 21 a-21 d) auf einer Oberfläche der fotoelektrischen Umwandlungsvorrichtung (20) umfasst, wobei die fotoelektrische Umwandlungseinheit (22) eine fotoelektrische Umwandlung von einem optischen Signal in ein elektrisches Signal oder von einem elektrischen Signal in ein optisches Signal durchführt, wobei sie Licht empfängt bzw. aussendet, und wobei der Verbinder (21, 21a-21d) die fotoelektrische Umwandlungsvorrichtung (20) mit einer weiteren Vorrichtung verbindet;
Herstellen eines elektrischen Leiters (30, 30a-30d), der mit dem Verbinder (21, 21 a-21 d) der fotoelektrischen Umwandlungsvorrichtung (20) verbunden ist und einen Lichtdurchlassabschnitt (31) zum Durchlassen von Licht in Richtung der fotoelektrischen Umwandlungseinheit (22) der verbundenen fotoelektrischen Umwandlungsvorrichtung (20) umfasst;
Herstellen eines zylindrischen Abschnitts (50), der so vorragt, dass er die weitere Linse (15) umgibt, und in den eine Kommunikationsleitung (9) zum Durchführen einer optischen Kommunikation eingepasst ist;
Herstellen einer Transparenzbewahrungseinheit (10), die für Licht durchlässig ist und den elektrischen Leiter (30, 30a-30d) stützt, dessen mit der fotoelektrischen Umwandlungsvorrichtung (20) verbundener Abschnitt freiliegend ist;
Herstellen einer Form zum Anformen einer Linse (14) und eines Abschnitts der Transparenzbewahrungseinheit (10);
Herstellen einer weiteren Form zum Anformen einer weiteren Linse (15) und eines weiteren Abschnitts der Transparenzbewahrungseinheit (10);
Bestimmen einer Position der fotoelektrischen Umwandlungsvorrichtung (20) relativ zu dem Abschnitt der Transparenzbewahrungseinheit (10) und anschließendem Verbinden eines Verbinders (21, 21 a-21 d) mit einem freiliegenden Abschnitt des elektrischen Leiters (30, 30a-30d); und
Formen der Transparenzbewahrungseinheit (10), der Linse (14) und der weiteren Linse (15) mit einem transparenten synthetischen Harz durch die Form und die weitere Form; wobei
die fotoelektrische Umwandlungsvorrichtung (20) eine Übertragung eines optischen Signals durch den zylindrischen Abschnitt (50), die Linsen (14, 15) der Transparenzbewahrungseinheit (10) und den Lichtdurchlassabschnitt (31) des elektrischen Leiters (30, 30a-30d) durchführt, und
eine Mitte der Linse (14) im Wesentlichen mit einer Mitte der fotoelektrischen Umwandlungseinheit (22) der fotoelektrischen Vorrichtung (20) übereinstimmt und eine Mitte der weiteren Linse (15) im Wesentlichen mit einer Mitte des zylindrischen Abschnitts (50) übereinstimmt.

11. Verfahren zum Herstellen eines optischen Kommunikationsmoduls nach Anspruch 10, das ferner umfasst:
Anordnen einer Positionierungseinheit (13), die auf der Transparenzbewahrungseinheit (10) vorragt; und
Bestimmen der Position der fotoelektrischen Umwandlungsvorrichtung (20) auf der Grundlage der Positionierungseinheit (13).

12. Verfahren zum Herstellen eines optischen Kommunikationsmoduls nach Anspruch 10 oder 11, das ferner umfasst:
Bilden eines Aussparungsabschnitts (12a) in der Transparenzbewahrungseinheit (10) zum Aufnehmen der fotoelektrische Umwandlungsvorrichtung (20); und
Verschließen des Aussparungsabschnitts (12a) durch eine Abdeckung (40), nachdem der Verbinder (21, 21a-21d) mit dem freiliegenden Abschnitt des elektrischen Leiters (30, 30a-30d) verbunden ist.

13. Verfahren zum Herstellen eines optischen Kommunikationsmoduls nach einem der Ansprüche 10 -12, das ferner umfasst:
Vereinzeln eines einteilig gebildeten Transparenzbewahrungseinheitenkomplexes (10), um diesen in mehrere der Transparenzbewahrungseinheiten (10) zu teilen und so die Transparenzbewahrungseinheit (10) herzustellen; und
Anordnen des elektrischen Leiters (30, 30a-30d) auf der abgeteilten Transparenzbewahrungseinheit (10).

14. Verfahren zum Herstellen eines optischen Kommunikationsmoduls nach Anspruch 13, das ferner umfasst:
Anformen eines Vorsprungs (313) auf jedem der abgetrennten Transparenzbewahrungseinheit (10); und
In-Eingriff-Bringen des Vorsprungs (313) mit einem Lochabschnitt (332), der auf dem elektrischen Leiter (30, 30a-30d) gebildet ist, um die Position des elektrischen Leiters (30, 30a-30d) zu bestimmen.

## Revendications

1. Module de communication optique, comprenant :
un dispositif de conversion photoélectrique (20) qui est doté d'une unité de conversion photoélectrique (22) et d'un connecteur (21, 21a - 21d) sur une surface du dispositif de conversion photoélectrique (20), dans lequel l'unité de conversion photoélectrique (22) met en oeuvre une conversion photoélectrique, d'un signal optique en un signal électrique, ou d'un signal électrique en un signal optique, avec une réception ou une émission de lumière, et le connecteur (21, 21a - 21d) connecte le dispositif de conversion photoélectrique (20) à un autre dispositif ;
un conducteur électrique (30, 30a - 30d) qui est connecté au connecteur (21, 21a - 21d) du dispositif de conversion photoélectrique (20) et qui est doté d'une partie de passage optique (31) permettant le passage de la lumière vers l'unité de conversion photoélectrique (22) du dispositif de conversion photoélectrique connecté (20) ;
une unité de maintien de transparence (10) qui laisse passer la lumière et prend en charge le conducteur électrique (30, 30a-30d), et dont la partie connectée au dispositif de conversion photoélectrique (20) est exposée ;
une lentille (14) formée d'un seul tenant sur une surface supérieure de l'unité de maintien de transparence (10) ;
une autre lentille (15) formée d'un seul tenant sur une surface inférieure de l'unité de maintien de transparence (10) ; et
une partie cylindrique (50) qui fait saillie pour entourer ladite autre lentille (15) ; dans lequel
le dispositif de conversion photoélectrique (20) est connecté à une partie exposée du conducteur électrique (30, 30a - 30d) ;
l'unité de conversion photoélectrique (22) est opposée à l'une des lentilles (14, 15) formées sur l'unité de maintien de transparence (10) ;
une transmission d'un signal optique est mise en oeuvre à travers les lentilles (14, 15) formées sur l'unité de maintien de transparence (10) et la partie de passage optique (31) du conducteur électrique (30, 30a - 30d) ;
la partie cylindrique (50) s'adapte en interne à une ligne de communication (9) en vue de mettre en oeuvre une communication optique ;
le dispositif de conversion photoélectrique (20) met en oeuvre une transmission d'un signal optique à travers l'intérieur de la partie cylindrique (50), les lentilles (14, 15) de l'unité de maintien de transparence (10) et la partie de passage optique (31) du conducteur électrique (30, 30a - 30d) ; et
un centre de la lentille (14) correspond sensiblement à un centre de l'unité de conversion photoélectrique (22) du dispositif photoélectrique (20), et un centre de l'autre lentille (15) correspond sensiblement à un centre de la partie cylindrique (50).

2. Module de communication optique selon la revendication 1, dans lequel :
la lentille (14) de l'unité de maintien de transparence (10) est formée d'un seul tenant par un moule différent d'un autre moule destiné à former d'un seul tenant ladite une autre lentille (15) de l'unité de maintien de transparence (10).

3. Module de communication optique selon la revendication 1 ou 2, comprenant en outre :
un couvercle (40) qui scelle une partie évidée (12a) qui est agencée sur l'unité de maintien de transparence (10) en vue d'accueillir le dispositif de conversion photoélectrique (20).

4. Module de communication optique selon l'une quelconque des revendications 1 à 3, comprenant en outre :
un composant de circuit électrique (61, 62) qui est connecté à la partie exposée du conducteur électrique (30, 30a - 30d).

5. Module de communication optique selon la revendication 4, comprenant en outre :
un autre conducteur électrique (30, 30a - 30d), dans lequel :
le dispositif de conversion photoélectrique (20) et le composant de circuit électrique (61, 62) sont connectés électriquement par le biais du conducteur électrique (30, 30a - 30d) et dudit un autre conducteur électrique (30, 30a - 30d), et configurent un circuit électrique pour mettre en oeuvre une conversion photoélectrique.

6. Module de communication optique selon la revendication 4 ou 5, dans lequel :
le composant de circuit électrique (61, 62) est connecté au conducteur électrique (30, 30a - 30d) avec un brasage tendre incluant un décapant.

7. Module de communication optique selon l'une quelconque des revendications 1 à 6, comprenant en outre :
une unité de positionnement (13) qui est agencée de manière à faire saillie sur l'unité de maintien de transparence (10) en vue de déterminer une position du dispositif de conversion photoélectrique (20).

8. Module de communication optique selon l'une quelconque des revendications 1 à 7, dans lequel :
l'unité de maintien de transparence (10) comprend une saillie (313) pour déterminer une position du conducteur électrique (30, 30a - 30d) ; et
le conducteur électrique (30, 30a - 30d) comprend une partie de trou (332) en prise avec la saillie (313) de l'unité de maintien de transparence (10).

9. Module de communication optique selon l'une quelconque des revendications 1 à 8, dans lequel :
une lumière parallèle passe entre la lentille (14) et ladite une autre lentille (15) à travers l'unité de maintien de transparence (10).

10. Procédé de fabrication d'un module de communication optique, comprenant les étapes ci-dessous consistant à :
préparer un dispositif de conversion photoélectrique (20) qui est doté d'une unité de conversion photoélectrique (22) et d'un connecteur (21, 21a - 21d) sur une surface du dispositif de conversion photoélectrique (20), dans lequel l'unité de conversion photoélectrique (22) met en oeuvre une conversion photoélectrique, d'un signal optique en un signal électrique, ou d'un signal électrique en un signal optique, avec une réception ou une émission de lumière, et le connecteur (21, 21a - 21d) connecte le dispositif de conversion photoélectrique (20) à un autre dispositif ;
préparer un conducteur électrique (30, 30a - 30d) qui est connecté au connecteur (21, 21a - 21d) du dispositif de conversion photoélectrique (20) et qui est doté d'une partie de passage optique (31) permettant le passage de la lumière vers l'unité de conversion photoélectrique (22) du dispositif de conversion photoélectrique connecté (20) ;
préparer une partie cylindrique (50) qui fait saillie pour entourer ladite autre lentille (15) et qui s'adapte en interne à une ligne de communication (9) en vue de mettre en oeuvre une communication optique;
préparer une unité de maintien de transparence (10) qui laisse passer la lumière et prend en charge le conducteur électrique (30, 30a-30d), et dont la partie connectée au dispositif de conversion photoélectrique (20) est exposée ;
préparer un moule destiné à former d'un seul tenant une lentille (14) et une partie de l'unité de maintien de transparence (10) ;
préparer un autre moule destiné à former d'un seul tenant une autre lentille (15) et une autre partie de l'unité de maintien de transparence (10) ;
déterminer une position du dispositif de conversion photoélectrique (20) par rapport à la partie de l'unité de maintien de transparence (10), et connecter ensuite le connecteur (21, 21a - 21 d) à une partie exposée du conducteur électrique (30, 30a - 30d) ; et
former d'un seul tenant l'unité de maintien de transparence (10), la lentille (14), et ladite autre lentille (15) avec une résine synthétique transparente, en utilisant le moule et ledit autre moule ; dans lequel
le dispositif de conversion photoélectrique (20) met en oeuvre une transmission d'un signal optique à travers l'intérieur de la partie cylindrique (50), les lentilles (14, 15) de l'unité de maintien de transparence (10) et la partie de passage optique (31) du conducteur électrique (30, 30a - 30d) ; et
un centre de la lentille (14) correspond sensiblement à un centre de l'unité de conversion photoélectrique (22) du dispositif photoélectrique (20), et un centre de ladite autre lentille (15) correspond sensiblement à un centre de la partie cylindrique (50).

11. Procédé de fabrication d'un module de communication optique selon la revendication 10, comprenant en outre les étapes ci-dessous consistant à
agencer une unité de positionnement (13) faisant saillie sur l'unité de maintien de transparence (10) ; et
déterminer la position du dispositif de conversion photoélectrique (20) sur la base de l'unité de positionnement (13).

12. Procédé de fabrication d'un module de communication optique selon la revendication 10 ou 11, comprenant en outre les étapes ci-dessous consistant à :
configurer une partie évidée (12a) dans l'unité de maintien de transparence (10) en vue d'accueillir le dispositif de conversion photoélectrique (20) ; et
sceller la partie évidée (12a) par un couvercle (40), suite à la connexion du connecteur (21, 21a - 21d) à la partie exposée du conducteur électrique (30, 30a - 30d).

13. Procédé de fabrication d'un module de communication optique selon l'une quelconque des revendications 10 à 12, comprenant en outre les étapes ci-dessous consistant à :
découper un complexe formé d'un seul tenant de l'unité de maintien de transparence (10) à séparer en plusieurs éléments de l'unité de maintien de transparence (10), en vue de préparer l'unité de maintien de transparence (10) ; et
agencer le conducteur électrique (30, 30a - 30d) sur l'unité de maintien de transparence séparée (10).

14. Procédé de fabrication d'un module de communication optique selon la revendication 13, comprenant en outre les étapes ci-dessous consistant à
former d'un seul tenant une saillie (313) sur chaque unité de maintien de transparence (10) séparée ; et
mettre en prise la saillie (313) avec une partie de trou (332) formée sur le conducteur électrique (30, 30a - 30d), en vue de déterminer la position du conducteur électrique (30, 30a - 30d).
